# EUROPEAN PATENT APPLICATION

(11) **EP 3 435 654 A1**
(43) Date of publication of application: **30.01.2019**
(21) Application number: 17770551.4
(22) Date of filing: 20.03.2017
(51) Int. Cl.: H04N 5/232, G06F 3/0487, G06F 3/0488

(54) **MOBILE TERMINAL FACILITATING IMAGE CAPTURE MODE SWITCHING, AND METHOD THEREFOR**

(30) Priority: 24.03.2016 KR 20160035117
(71) Applicant: Hideep Inc., Seongnam-si, Gyeonggi-do 13493 (KR)
(72) Inventor: KIM, Se Yeob, Seongnam-si Gyeonggi-do 13493 (KR); KIM, Yun Joung, Seongnam-si Gyeonggi-do 13493 (KR)
(74) Representative: Patronus IP Patent- und Rechtsanwälte
(86) International application number: PCT/KR2017/002926
(87) International publication number: WO 2017/164581

(57) **Abstract**

A mobile terminal may be provided that includes: a touch screen which detects touch information including a touch pressure; a camera unit which is operable in a plurality of photographing modes; a control unit which, when a touch pressure having a magnitude greater than a predetermined magnitude is applied to the touch screen while photographing a subject in a first photographing mode among the plurality of photographing modes, switches the photographing mode to a second photographing mode and controls the subject to be photographed. Since the mobile terminal according to the embodiment of the present invention uses a control method based on a touch pressure, it is possible to very easily switching various photographing modes including the picture photographing mode and the video photographing mode.

## Description

### TECHNICAL FIELD

The present disclosure relates to a mobile terminal capable of easily switching photographing modes and a method for switching the photographing modes, and more particularly to a mobile terminal capable of easily switching photographing modes on the basis of a touch having a pressure and a method for switching the photographing modes.

### BACKGROUND ART

Various kinds of input devices for operating a computing system, such as a button, key, joystick, touch screen, etc., are being developed and used. The touch screen has a variety of advantages, e.g., ease of operation, miniaturization of products and simplification of the manufacturing process, so that the most attention is paid to the touch screen.

The touch screen can constitute a touch surface of a touch input device including a touch sensor panel. The touch sensor panel is attached to the front side of the touch screen, and then covers the touch screen. A user is able to operate the corresponding device by touching the touch screen with his/her finger. The corresponding device detects whether or not the touch of the user occurs and the position of the touch, performs operations, and performs operations corresponding to the user's operation.

Most devices (e.g., a mobile terminal, PDA, etc.) employing the touch screen determines whether a user touches or not and a touch position, and then performs a specific operation. Specifically, when the user touches an area where an application is displayed, the device detects the position where the touch has occurred, and executes, drives, or terminates the application. Each device may also execute the application on the basis of a touch time, the number of touches, or patterns. For example, an object which is displayed by a long touch, a double touch, a multi touch, etc., can be performed in various ways.

However, in the above-mentioned conventional touch control method, since a specific operation is performed based on the touch position, patterns, and touch time, controllable operations are limited. With the current viewpoint that the functions of various devices are being integrated and are being gradually diversified, there is a requirement for a new touch method departing from the conventional touch control method.

However, it is not easy to not only reproduce the conventional touch control method as it is but also implement a new touch method at the same time. Also, it is difficult to detect the two methods at the same time without depending on time division.

### DISCLOSURE

### Technical Problem

The present invention is designed in consideration of the above problems. The object of the present invention is to provide a mobile terminal capable of executing various applications by using a new touch type based on a touch pressure. Particularly, the object of the present invention is to provide a mobile terminal capable of easily switching a picture photographing mode and a video photographing mode and a method for switching the photographing modes.

### Technical Solution

One embodiment is a mobile terminal that includes: a touch screen which detects touch information including a touch pressure; a camera unit which is operable in a plurality of photographing modes; a control unit which, when a touch pressure having a magnitude greater than a predetermined magnitude is applied to the touch screen while photographing a subject in a first photographing mode among the plurality of photographing modes, switches the photographing mode to a second photographing mode and controls the subject to be photographed.

When the touch pressure is released, the control unit may switch the photographing mode to the first photographing mode again and control the subject to be photographed.

The mobile terminal may further include a mode setting unit which sets the first photographing mode and the second photographing mode on the basis of a touch input through the touch screen. The control unit may control switching of the photographing modes on the basis of the first photographing mode and the second photographing mode which are set in the mode setting unit.

The mobile terminal may further include a memory which stores an image obtained by the camera unit. The control unit may control the image stored in the memory to be displayed on the touch screen.

The first photographing mode may be a picture photographing mode for photographing a still image, and the second photographing mode may be a video photographing mode for photographing a dynamic image.

The control unit may control video photographing to be started at a point of time when the touch pressure is released.

The control unit may control the video photographing to be started at a point of time when the photographing mode is switched to the video photographing mode, and control the video photographing to be ended when the touch pressure is released.

The control unit may control the photographed video image to be stored when the touch pressure is released, and then switch the photographing mode to the first photographing mode again.

The camera unit may include a first camera and a second camera which are spaced by a predetermined distance from each other. The first photographing mode may be a 2D photographing mode for photographing a 2D image by using one of the first camera and the second camera. The second photographing mode may be a 3D photographing mode for photographing a 3D image by using the first camera and the second camera.

The camera unit may further include a 3D image generator which reconstructs a 3D image by using the image obtained by the first camera and the second camera.

The camera unit may include a first camera and a second camera, and one or more of an angle of view, a minimum aperture value, a shortest object distance, a zoom magnification, the number of pixels, and ISO of the first and second cameras are different from each other. The first photographing mode may be a mode for photographing an image by using the first camera. The second photographing mode may be a mode for photographing an image by using the second camera.

The camera unit may include a front side camera disposed on a front side of the mobile terminal and a rear side camera disposed on a rear side of the mobile terminal. The first photographing mode may be a front camera mode for photographing by using the front side camera. The second photographing mode may be a rear camera mode for photographing by using the rear side camera.

The first photographing mode may be a picture photographing mode for photographing a still image. The second photographing mode may be a depth-of-field control mode for pan-focusing photographing or out-focusing photographing. When the photographing mode is switched to the second photographing mode, the camera unit may photograph the image by controlling a depth-of-field on the basis of at least one of an aperture value and a focal length.

The control unit may control a pan-focusing image or an out-focusing image of the subject to be photographed, on the basis of at least one of the touch pressure and a movement direction of the touch.

The control unit may control the depth-of-field of the image to gradually decrease when an intensity of the touch pressure increases. The control unit may control the depth-of-field of the image to gradually increase when the intensity of the touch pressure decreases.

The first photographing mode may be a video photographing mode for photographing a dynamic image, and the second photographing mode may be a speed control photographing mode for high speed photographing or low speed photographing. The control unit may control the image to be photographed at a low speed or at a high speed by controlling the number of frames obtained according to time.

The control unit may select one of the low speed photographing and the high speed photographing on the basis of at least one of an intensity of the touch pressure and a movement direction of the touch.

The first photographing mode may be a picture photographing mode for photographing a still image, and the second photographing mode may be for photographing a panoramic image.

When the photographing mode is switched to the second photographing mode, the touch screen may display a guide line for guiding a movement direction of the camera.

The control unit may control panoramic photographing to be started at a point of time when the touch pressure is released.

The control unit may control the panoramic photographing to be started at a point of time when the photographing mode is switched to the panoramic photographing mode, and control the panoramic photographing to be ended at a point of time when the touch pressure is released.

The second photographing mode may be a white balance adjustment mode for controlling a color temperature of an image. The control unit may control the color temperature of the image to be controlled on the basis of at least one of an intensity of the touch pressure and a movement direction of the touch.

The touch screen may display a change of a numerical value of the color temperature based on at least one of the intensity of the touch pressure and the movement of the touch.

The second photographing mode may be a timer photographing mode for photographing an image after a predetermined time is counted. The control unit may control the image to be obtained after the predetermined time is counted after the photographing is started.

The predetermined time may be a time from when the photographing mode is switched to the timer photographing mode to when the touch pressure is released. The control unit may control the image to be obtained at a point of time when the touch pressure is released.

The touch screen may display the predetermined time or a change of time which is counted.

The second photographing mode may be a filter application mode for obtaining a filtered image. When the photographing mode is switched to the filter application mode, the touch screen may display each filtered image filtered by a plurality of filters. When a user' touch is located at one of areas where the plurality of filtered images are located, the touch screen may display only the filtered images displayed in the corresponding area on the full screen.

The touch screen may include a pressure electrode and a reference potential layer. The control unit may determine whether or not the touch pressure having a magnitude greater than a predetermined magnitude is applied on the basis of a capacitance change amount according to a change of a distance between the pressure electrode and the reference potential layer, which is changed by the touch pressure.

Another embodiment is a method for switching photographing modes in a mobile terminal which includes a camera unit photographing a subject and a touch screen capable of detecting a touch pressure. The method includes: an initial photographing step of photographing a subject in a first photographing mode; a displaying step of displaying the obtained image on the touch screen; a determining step of determining whether a touch pressure having a magnitude greater than a predetermined magnitude is applied to the touch screen or not; and a switching photographing step of, when the touch pressure having a magnitude greater than the predetermined magnitude is applied, switching the photographing mode from the first photographing mode to a second photographing mode and of photographing an image.

The method may further include a step of switching the photographing mode to the first photographing mode again when the touch pressure is released and of controlling the subject to be photographed.

The method may further include a step of setting the first photographing mode and the second photographing mode on the basis of a touch input through the touch screen.

The method may further include a step of storing the image obtained in the first photographing mode and the second photographing mode; and a step of reading the stored image and displaying on the touch screen.

The first photographing mode may be a picture photographing mode for photographing a still image, and the second photographing mode may be a video photographing mode for photographing a dynamic image. In the switching photographing step, video photographing may be started at a point of time when the touch pressure is released.

The first photographing mode may be a picture photographing mode for photographing a still image, and the second photographing mode may be a video photographing mode for photographing a dynamic image. In the switching photographing step, video photographing may be started at a point of time when the photographing mode is switched to the video photographing mode, and the video photographing may be ended when the touch pressure is released.

The method may further include a step of storing the photographed video image when the touch pressure is released, and of switching the photographing mode to the first photographing mode again.

The camera unit may include a first camera and a second camera which are spaced by a predetermined distance from each other. The first photographing mode may be a 2D photographing mode for photographing a 2D image by using one of the first camera and the second camera, and the second photographing mode may be a 3D photographing mode for photographing a 3D image by using the first camera and the second camera. The method may further include a step of reconstructing a 3D image by using the image obtained by the first camera and the second camera.

The camera unit may include a first camera and a second camera, and one or more of an angle of view, a minimum aperture value, a shortest object distance, a zoom magnification, the number of pixels, and ISO of the first and second cameras are different from each other. The first photographing mode may be a mode for photographing an image by using the first camera, and the second photographing mode may be a mode for photographing an image by using the second camera.

The camera unit may include a front side camera disposed on a front side of the mobile terminal and a rear side camera disposed on a rear side of the mobile terminal. The first photographing mode may be a front camera mode for photographing by using the front side camera, and the second photographing mode may be a rear camera mode for photographing by using the rear side camera.

The first photographing mode may be a picture photographing mode for photographing a still image, and the second photographing mode may be a depth-of-field control mode for pan-focusing photographing or out-focusing photographing. In the switching photographing step, the photographing may be performed by controlling a depth-of-field of the image on the basis of at least one of an aperture value and a focal length.

In the switching photographing step, a pan-focusing image or an out-focusing image of the subject may be photographed on the basis of at least one of the touch pressure and a movement direction of the touch.

In the switching photographing step, the depth-of-field of the image may be controlled to gradually decrease when an intensity of the touch pressure increases, and the depth-of-field of the image is controlled to gradually increase when the intensity of the touch pressure decreases.

The first photographing mode may be a video photographing mode for photographing a dynamic image. The second photographing mode may be a speed control photographing mode for high speed photographing or low speed photographing. In the switching photographing step, the image may be photographed at a low speed or at a high speed by controlling the number of frames obtained according to time.

In the switching photographing step, one of the low speed photographing and the high speed photographing may be selected on the basis of at least one of an intensity of the touch pressure and a movement direction of the touch.

The first photographing mode may be a picture photographing mode for photographing a still image, and the second photographing mode may be a panoramic photographing mode for photographing a panoramic image. In the switching photographing step, a guide line for guiding a movement direction of the camera may be displayed.

In the switching photographing step, panoramic photographing may be started at a point of time when the touch pressure is released.

In the switching photographing step, the panoramic photographing may be started at a point of time when the photographing mode is switched to the panoramic photographing mode, and the panoramic photographing may be ended at a point of time when the touch pressure is released.

The second photographing mode may be a white balance adjustment mode for controlling a color temperature of an image. In the switching photographing step, the color temperature of the image may be controlled on the basis of at least one of an intensity of the touch pressure and a movement direction of the touch.

In the switching photographing step, a change of a numerical value of the color temperature based on at least one of the intensity of the touch pressure and the movement of the touch may be displayed.

The second photographing mode may be a filter application mode for obtaining a filtered image. In the switching photographing step, the touch screen may display each filtered image filtered by a plurality of filters, and when a user' touch is located at one of areas where the plurality of filtered images are located, the touch screen may display only the filtered images displayed in the corresponding area on the full screen.

The second photographing mode may be a timer photographing mode for photographing an image after a predetermined time is counted. In the switching photographing step, the image may be obtained after the predetermined time is counted after the photographing is started.

The predetermined time may be a time from when the photographing mode is switched to the timer photographing mode to when the touch pressure is released. In the switching photographing step, the image may be obtained at a point of time when the touch pressure is released.

In the switching photographing step, the predetermined time or a change of time which is counted may be displayed on the touch screen.

The touch screen may include a pressure electrode and a reference potential layer. In the determining step, it may be determined whether or not the touch pressure having a magnitude greater than a predetermined magnitude is applied to the touch screen, on the basis of a capacitance change amount according to a change of a distance between the pressure electrode and the reference potential layer, which is changed by the touch pressure.

### Advantageous Effects

Since the mobile terminal and the method for switching the photographing modes use a control method based on a touch pressure, it is possible to very easily switching various photographing modes including the picture photographing mode and the video photographing mode.

### DESCRIPTION OF DRAWINGS

Fig. 1 is a block diagram showing the configuration of a mobile terminal according to an embodiment of the present invention;
Fig. 2 shows a layer structure of a touch screen of the mobile terminal according to the embodiment of the present invention;
Figs. 3a and 3b are views for describing the structure and operation of a touch input unit included in the touch screen of the mobile terminal according to the embodiment of the present invention;
Figs. 4a to 4e are views showing the structure of a display included in the touch screen of the mobile terminal according to the embodiment of the present invention;
Figs. 5a to 5d are views for describing a method for detecting whether a 3D touch has occurred or not and/or the strength of the touch on the basis of a mutual capacitance in the mobile terminal according to the embodiment of the present invention;
Figs. 6a to 6c show a method for detecting whether a 3D touch has occurred or not and/or the strength of the touch on the basis of a self-capacitance in the mobile terminal according to the embodiment of the present invention;
Figs. 7a and 7b show a user interface for setting photographing modes in the mobile terminal according to the embodiment of the present invention;
Fig. 8 is a view showing a method for switching the photographing modes in accordance with a first embodiment in the mobile terminal according to the embodiment of the present invention;
Fig. 9 is a view showing a method for switching the photographing modes in accordance with a second embodiment in the mobile terminal according to the embodiment of the present invention;
Fig. 10 is a view showing a method for switching the photographing modes in accordance with a third embodiment in the mobile terminal according to the embodiment of the present invention;
Fig. 11 is a view showing a method for switching the photographing modes in accordance with a fourth embodiment in the mobile terminal according to the embodiment of the present invention;
Fig. 12 is a view showing a method for switching the photographing modes in accordance with a fifth embodiment in the mobile terminal according to the embodiment of the present invention;
Fig. 13 is a view showing a method for switching the photographing modes in accordance with a sixth embodiment in the mobile terminal according to the embodiment of the present invention;
Fig. 14 is a view showing a method for switching the photographing modes in accordance with a seventh embodiment in the mobile terminal according to the embodiment of the present invention;
Fig. 15 is a view showing a method for switching the photographing modes in accordance with an eighth embodiment in the mobile terminal according to the embodiment of the present invention;
Fig. 16 is a view showing a method for switching the photographing modes in accordance with a ninth embodiment in the mobile terminal according to the embodiment of the present invention;
Fig. 17 is a view showing a method for switching the photographing modes in accordance with a tenth embodiment in the mobile terminal according to the embodiment of the present invention; and
Fig. 18 is a flowchart showing a method for switching the photographing modes according to the embodiment of the present invention.

### MODE FOR INVENTION

Specific embodiments of the present invention will be described in detail with reference to the accompanying drawings. The specific embodiments shown in the accompanying drawings will be described in enough detail that those skilled in the art are able to embody the present invention. Other embodiments other than the specific embodiments are mutually different, but do not have to be mutually exclusive. Additionally, it should be understood that the following detailed description is not intended to be limited.

The detailed descriptions of the specific embodiments shown in the accompanying drawings are intended to be read in connection with the accompanying drawings, which are to be considered part of the entire written description. Any reference to direction is merely intended for convenience of description and is not intended in any way to limit the scope of the present invention.

A mobile terminal according to an embodiment of the present invention is a device including a display and a touch input unit and can be understood as a term covering portable electronic products such as a camera, a camcorder, an electronic dictionary, etc., as well as a smartphone, a smart watch, a tablet PC, a laptop computer, a personal digital assistant (PDA), and an MP3 player. However, the mobile terminal is not limited to this.

In addition, the mobile terminal means a portable terminal which has a communication function. That is, the mobile terminal should be construed to include not only communication devices, for example, a mobile phone equipped with a communication function but also devices, for example, a camera, a camcorder, etc., which is not equipped with a communication function, but can include the communication function.

### Configuration of a Mobile Terminal 1000

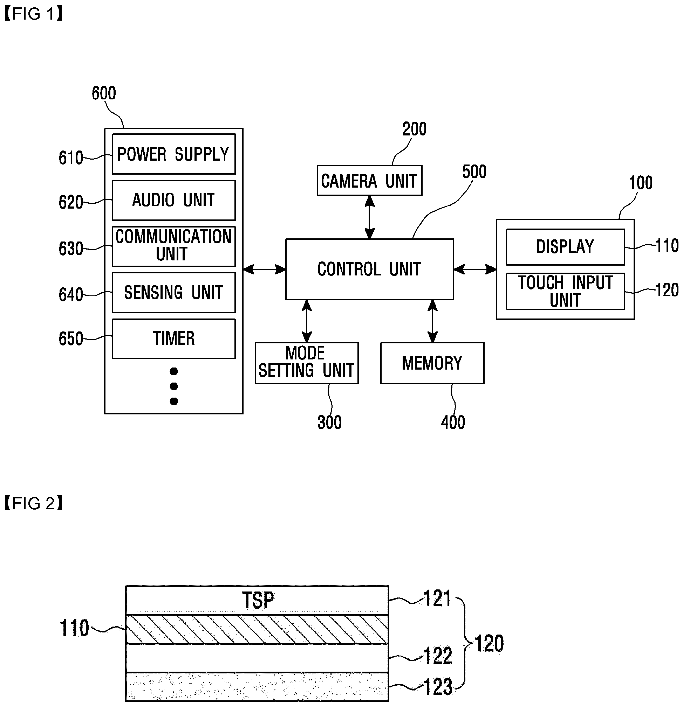

Fig. 1 is a block diagram showing the configuration of a mobile terminal 1000 according to an embodiment of the present invention. As shown in Fig. 1, the mobile terminal 1000 may include a touch screen 100, a camera unit 200, a mode setting unit 300, a memory 400, a control unit 500, and other units 600. The other units 600 may include a power supply 610, an audio unit 620, a communication unit 630, a sensing unit 640, and a timer 650 which perform basic functions and maintain the performance of the mobile terminal 1000 according to the embodiment of the present invention.

The touch screen 100 includes a display 110 and a touch input unit 120 and functions as a display means and an input means. Here, the function as an input means includes detecting a user's touch occurring on the surface (a polarizer of a touch sensor panel and a display panel) of the touch screen 100, and performing various operations (e.g., application execution, voice/video call, etc.) on the basis of information on the touch.

The touch information includes 2D touch information and 3D touch information. That is, the touch information includes the 2D touch information on whether the touch is input or not (whether the touch occurs or not) and on which position in the surface of the touch screen the touch is input to. Furthermore, the touch information may further include the 3D touch information on whether the touch is a 2D touch or whether or not the touch is a 3D touch with a pressure having a magnitude greater than a predetermined magnitude.

Here, the 3D touch may mean a touch having a sufficient pressure for the surface of the touch screen to be bent at the position of the user's touch applied to the surface of the touch screen. However, in another embodiment, the 3D touch may mean a touch which has a pressure sufficient to be sensed by a separate pressure sensor even without the bending of the touch screen surface.

The structure, function, and operation of the display 110 and the touch input unit 120 will be described below in more detail.

Regarding the camera unit200, light received through a lens is sensed by an image sensor and is converted into digital information, and then is reconstructed into digital images through image processing. Here, the image sensor may be a charge coupled device (CCD) sensor and a complementary metal-oxide semiconductor (CMOS) sensor. The digital image may be generated by a format for still images such as RAW, JPEG, TIFF, GIF, MPO, etc., or a format for dynamic images such as AVI, MPEG, DV, MOV, MJPEG, etc.

Meanwhile, the camera unit 200 may include two or more cameras. One or more of the angle of view, the shortest object distance, the zoom magnification, and the minimum aperture value of a lens provided in each camera may be different from each other. Also, the number of pixels and ISO of the image sensors provided in the respective cameras may be different from each other. The number of pixels means the number of pixels where the image sensor senses photons. The number of pixels determines the size and resolution (definition) of the image. ISO means a sensitivity value with which the image sensor respond to light, and determines the amount of light at the time of photographing the image.

Also, the camera unit 200 may include two cameras. One may be disposed on the front side of the mobile terminal 1000, and the other may be disposed on the rear side of the mobile terminal 1000. Here, the front side means a side provided with the touch screen 1000, and the rear side means a side opposite to the front side. The camera disposed on the front side and the camera disposed on the rear side may be implemented with the same specification, or may be implemented such that one or more of the angle of view, the shortest object distance, the zoom magnification, the minimum aperture value, the number of pixels, and ISO may be different from each other.

Also, the camera unit 200 may include two cameras which are spaced by a predetermined distance from each other. The two cameras may be disposed on the rear side of the mobile terminal 1000. Meanwhile, the camera unit 200 may further include a 3D image generator. The 3D image generator generates 3D images based on images obtained at different angles by the two cameras.

The mode setting unit 300 has a function of setting a photographing mode of the camera unit 200. As will be described in detail below, the mode setting unit 300 sets the photographing mode of the camera unit 200 on the basis of the user's touch input through the touch screen 100.

The photographing mode of the camera unit 200 includes a picture photographing mode for photographing a still image, a video photographing mode for photographing a dynamic image, an out-focusing photographing mode for photographing an out-focusing image, a panoramic photographing mode for photographing a panoramic image, a white balance adjustment mode capable of adjusting white balance, a filter application mode for generating a filtered image, a timer photographing mode for timer photographing, a speed control photographing mode for high speed photographing or low speed photographing, a depth-of-field control mode for pan-focusing photographing and out-focusing photographing, a 2D photographing mode, a 3D photographing mode, a front camera mode, a rear camera mode, and a multiple specification camera mode.

The mobile terminal 1000 according to the embodiment of the present invention can provide an interface for facilitating a user setting related to the photographing mode. The interface may be implemented in the form of displaying texts, colors, icons, etc., on the touch screen 100.

The memory 400 has a function of storing various image files generated by the camera unit 200 or storing the photographing mode set by the mode setting unit 300. The image stored in the memory 400 can be controlled to be displayed through the touch screen 100 on the basis of a user operation signal.

The control unit 500 controls the touch screen 100, the camera unit 200, the mode setting unit 300, the memory 400, and below-described other units 600 to perform a specific operation on the basis of a user operation (command) input from the touch screen 100. The control of the control unit 500 will be described in detail below together with specific embodiments.

As other configurations, the other units 600 may include the power supply 610 which supplies power for operating each of the components, the audio unit 620 which is involved in the input and output of voice and sound, the communication unit 630 which performs voice communication with a communication terminal or performs data communication with a server, the sensing unit 640 which includes a gyro sensor, an acceleration sensor, a vibration sensor, a proximity sensor, a magnetic sensor, etc., and the timer 650 which checks a call time period, a touch duration time, etc. However, the above components may be omitted or replaced if necessary, or alternatively, other components may be added.

### Structure of Touch Screen 100

Fig. 2 shows a layer structure of the touch screen 100 of the mobile terminal 1000 according to the embodiment of the present invention. As shown in Fig. 2, the touch screen 100 of the mobile terminal 1000 according to the embodiment of the present invention includes a touch sensor panel 121, the display 110, a pressure detection module 122, and a substrate 123. In Fig. 2, the touch sensor panel 121, the pressure detection module 122, and the substrate 123 may correspond to the touch input unit 120 of Fig. 1, and the display 110 may correspond to the display 110 of Fig. 1.

The display 110 has a function of displaying texts, images (still images, dynamic images, 3D images, etc.), colors, and the like.

The touch sensor panel 121 detects information on the 2D touch. The 2D touch is a term corresponding to the 3D touch to be described below, and refers to a touch that is merely contact or a touch that has a pressure having a magnitude less than a predetermined magnitude. Specifically, the 2D touch may mean a touch having a force enough for the touch screen not to be bent or a touch having a force enough for a separate pressure sensor not to recognize the touch as a pressure.

That is, the information on the 2D touch refers to information on whether or not the touch occurs on the touch screen surface, the position and the number of touches occurring on the touch screen surface, and the touch movement direction.

The pressure detection module 122 detects information on the 3D touch. The 3D touch is a term corresponding to the above 2D touch and means a touch that has a pressure having a magnitude greater than a predetermined magnitude. Specifically, the 3D touch may mean a touch having a force enough for the touch screen to be bent or a touch having a force enough for a separate pressure sensor to recognize the touch as a pressure.

That is, the information on the 3D touch refers to information on the strength or strength change of the 3D touch, the duration time of the 3D touch, and the like.

The substrate 123 may be a reference potential layer used for 3D touch detection. In Fig. 2, although the reference potential layer is disposed under the pressure detection module 122, the reference potential layer may be disposed on the pressure detection module 122 or within the display 110 in other embodiments.

Further, although one reference potential layer (substrate 123) is shown in Fig. 2, two or more reference potential layers may be used in other embodiments. The arrangement and the number of the pressure detecting modules 122 can be appropriately changed, as necessary.

### 2D Touch Detection

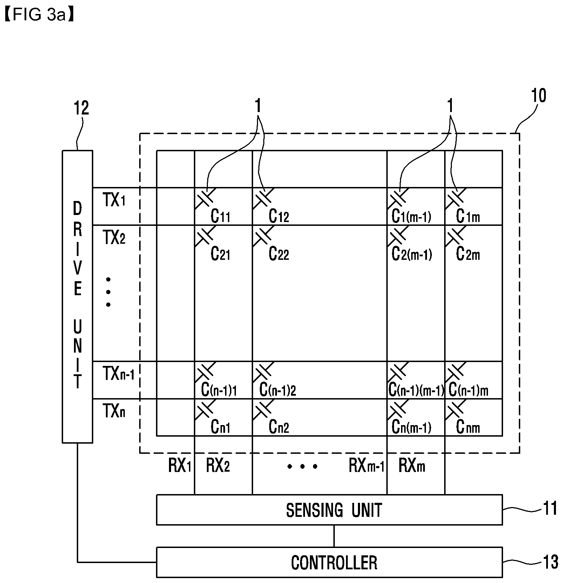

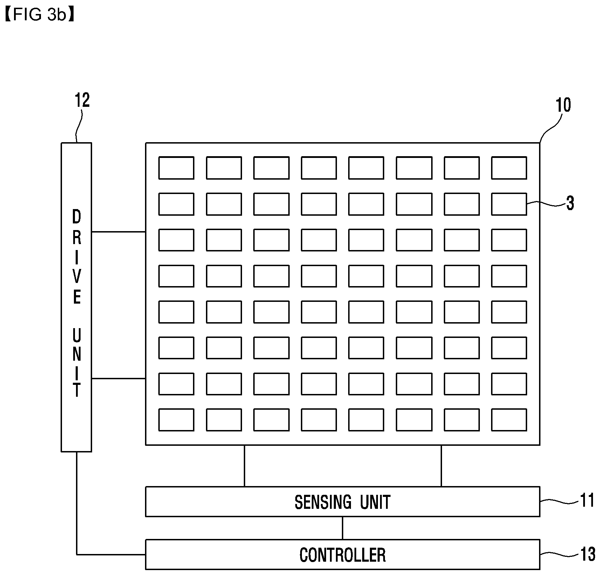

Figs. 3a and 3b are views for describing the structure and operation of the touch input unit 120 included in the touch screen 100 of the mobile terminal 1000 according to the embodiment of the present invention. Specifically, Figs. 3a and 3b show the structure and operation of the touch sensor panel 121 of Fig. 2.

Fig. 3a is a schematic view of a configuration of a mutual capacitance touch sensor panel 121 and the operation thereof in accordance with the embodiment of the present invention. Referring to Fig. 3a, the touch sensor panel 121 may include a plurality of drive electrodes TX1 to TXn and a plurality of receiving electrodes RX1 to RXm, and may include a drive unit 12 which applies a drive signal to the plurality of drive electrodes TX1 to TXn for the purpose of the operation of the touch sensor panel 121, and a sensing unit 11 which detects whether the touch has occurred or not and/or the touch position by receiving a sensing signal including information on the capacitance change amount changing according to the touch on the touch surface of the touch sensor panel 121.

As shown in Fig. 3a, the touch sensor panel 121 may include the plurality of drive electrodes TX1 to TXn and the plurality of receiving electrodes RX1 to RXm. Fig. 3 shows that the plurality of drive electrodes TX1 to TXn and the plurality of receiving electrodes RX1 to RXm of the touch sensor panel 121 form an orthogonal array. In another embodiment, the plurality of drive electrodes TX1 to TXn and the plurality of receiving electrodes RX1 to RXm may form an array of different patterns.

The drive electrode TX may include the plurality of drive electrodes TX1 to TXn extending in a first axial direction. The receiving electrode RX may include the plurality of receiving electrodes RX1 to RXm extending in a second axial direction crossing the first axial direction.

In the touch sensor panel 121, the plurality of drive electrodes TX1 to TXn and the plurality of receiving electrodes RX1 to RXm may be formed in the same layer. For example, the plurality of drive electrodes TX1 to TXn and the plurality of receiving electrodes RX1 to RXm may be formed on the same side of an insulation layer (not shown). Also, the plurality of drive electrodes TX1 to TXn and the plurality of receiving electrodes RX1 to RXm may be formed in different layers. For example, the plurality of drive electrodes TX1 to TXn and the plurality of receiving electrodes RX1 to RXm may be formed on both sides of one insulation layer (not shown) respectively, or the plurality of drive electrodes TX1 to TXn may be formed on a side of a first insulation layer (not shown) and the plurality of receiving electrodes RX1 to RXm may be formed on a side of a second insulation layer (not shown) different from the first insulation layer.

The plurality of drive electrodes TX1 to TXn and the plurality of receiving electrodes RX1 to RXm may be made of a transparent conductive material (for example, indium tin oxide (ITO) or antimony tin oxide (ATO) which is made of tin oxide (SnO₂), and indium oxide (In₂O₃), etc.), or the like. However, this is only an example. The drive electrode TX and the receiving electrode RX may be also made of another transparent conductive material or an opaque conductive material. For instance, the drive electrode TX and the receiving electrode RX may include at least any one of silver ink, copper, and carbon nanotube (CNT). Also, the drive electrode TX and the receiving electrode RX may be made of metal mesh or nano silver.

The drive unit 12 may apply a drive signal to the drive electrodes TX1 to TXn. In the embodiment of the present invention, one drive signal may be sequentially applied at a time to the first drive electrode TX1 to the n-th drive electrode TXn. The drive signal may be applied again repeatedly. This is only an example. The drive signal may be applied to the plurality of drive electrodes at the same time in accordance with the embodiment.

Through the receiving electrodes RX1 to RXm, the sensing unit 11 receives the sensing signal including information on a capacitance (Cm) 1 generated between the receiving electrodes RX1 to RXm and the drive electrodes TX1 to TXn to which the drive signal has been applied, thereby detecting whether or not the touch has occurred and the touch position. For example, the sensing signal may be a signal coupled by the capacitance (CM) 1 generated between the receiving electrode RX and the drive electrode TX to which the drive signal has been applied. As such, the process of sensing the drive signal applied from the first drive electrode TX1 to the n-th drive electrode TXn through the receiving electrodes RX1 to RXm can be referred to as a process of scanning the touch sensor panel 100. As such, the process of sensing the drive signal applied from the first drive electrode TX1 to the n-th drive electrode TXn through the receiving electrodes RX1 to RXm can be referred to as a process of scanning the touch sensor panel 100.

For example, the sensing unit 11 may include a receiver (not shown) which is connected to each of the receiving electrodes RX1 to RXm through a switch. The switch becomes the on-state in a time interval during which the signal of the corresponding receiving electrode RX is sensed, thereby allowing the receiver to sense the sensing signal from the receiving electrode RX. The receiver may include an amplifier (not shown) and a feedback capacitor coupled between the negative (-) input terminal of the amplifier and the output terminal of the amplifier, i.e., coupled to a feedback path. Here, the positive (+) input terminal of the amplifier may be connected to the ground. Also, the receiver may further include a reset switch which is connected in parallel with the feedback capacitor. The reset switch may reset the conversion from current to voltage that is performed by the receiver. The negative input terminal of the amplifier is connected to the corresponding receiving electrode RX and receives and integrates a current signal including information on the capacitance (CM) 1, and then converts the integrated current signal into voltage. The sensing unit 11 may further include an analog to digital converter (ADC) (not shown) which converts the integrated data by the receiver into digital data. Later, the digital data may be input to a processor (not shown) and processed to obtain information on the touch on the touch sensor panel 121. The sensing unit 11 may include the ADC and processor as well as the receiver.

A controller 13 may perform a function of controlling the operations of the drive unit 12 and the sensing unit 11. For example, the controller 13 generates and transmits a drive control signal to the drive unit 12, so that the drive signal can be applied to a predetermined drive electrode TX1 at a predetermined time. Also, the controller 13 generates and transmits a sensing control signal to the sensing unit 11, so that the sensing unit 11 may receive the sensing signal from the predetermined receiving electrode RX at a predetermined time and perform a predetermined function.

In Fig. 3a, the drive unit 12 and the sensing unit 11 may constitute a touch detection device (not shown) capable of detecting whether or not the touch has occurred on the touch screen 100 and the touch position in the mobile terminal 1000 according to the embodiment of the present invention. The touch detection device may further include the controller 13. The touch detection device may be integrated and implemented on a touch sensing integrated circuit (IC) in the mobile terminal 1000 including the touch sensor panel 121. The drive electrode TX and the receiving electrode RX included in the touch sensor panel 121 may be connected to the drive unit 12 and the sensing unit 11 included in the touch sensing IC (not shown) through, for example, a conductive trace and/or a conductive pattern printed on a circuit board, or the like. The touch sensing IC may be placed on a circuit board on which the conductive pattern has been printed, for example, a first printed circuit board (hereafter, referred to as a first PCB). According to the embodiment, the touch sensing IC may be mounted on a main board for operation of the mobile terminal 1000.

As described above, a capacitance (Cm) 1 with a predetermined value is generated at each crossing of the drive electrode TX and the receiving electrode RX. When an object U like a finger, palm, or stylus, etc., approaches close to the touch sensor panel 121, the value of the capacitance may be changed.

In Fig. 3a, the capacitance may represent a mutual capacitance (Cm). The sensing unit 11 senses such electrical characteristics, thereby being able to sense whether the touch has occurred on the touch sensor panel 121 or not and where the touch has occurred. For example, the sensing unit 11 is able to sense whether the touch has occurred on the surface of the touch sensor panel 121 comprised of a two-dimensional plane consisting of a first axis and a second axis.

More specifically, when the touch occurs on the touch sensor panel 121, the drive electrode TX to which the drive signal has been applied is detected, so that the position of the second axial direction of the touch can be detected. Likewise, when the touch occurs on the touch sensor panel 121, the capacitance change is detected from the reception signal received through the receiving electrode RX, so that the position of the first axial direction of the touch can be detected.

In the foregoing, the operation method of the touch sensor panel 121 which detects whether the touch has occurred or not or the touch position has been described based on the change amount of the mutual capacitance (Cm) between the drive electrode TX and the receiving electrode RX. However, there is no limitation to this. As shown in Fig. 3b, the touch position can be also detected based on the change amount of a self-capacitance.

As shown in Fig. 3b, the touch sensor panel 121 may include a plurality of touch electrodes 3. The plurality of touch electrodes 3 may be arranged at a regular interval in the form of a grid. However, there is no limitation to this.

The drive control signal generated by the controller 13 is transmitted to the drive unit 12, and the drive unit 12 applies the drive signal to a predetermined touch electrode 3 for a predetermined time. Also, the sensing control signal generated by the controller 13 is transmitted to the sensing unit 11, and on the basis of the detection control signal, the sensing unit 11 receives the sensing signal from the predetermined touch electrode 3 for a predetermined time. Here, the sensing signal may be a signal for the change amount of the self-capacitance formed on the touch electrode 3.

Here, whether or not the touch has occurred on the touch sensor panel 121 and/or the touch position are detected by the sensing signal detected by the sensing unit 11. For example, because the coordinates of the touch electrode 3 have been known in advance, whether or not the touch of the object U has occurred on the surface of the touch sensor panel 121 and/or the touch position can be detected.

Referring to Figs. 3a and 3b, the foregoing has described in detail the touch sensor panel 121 which detects whether or not the touch has occurred and/or the touch position on the basis of the change amount of the mutual capacitance (Cm) and the change amount of the self-capacitance (Cs). However, the touch sensor panel 121 may be implemented by using not only the above-described methods but also any touch sensing method such as a surface capacitance type method, a projected capacitance type method, a resistance film method, a surface acoustic wave (SAW) method, an infrared method, an optical imaging method, a dispersive signal technology, and an acoustic pulse recognition method, etc.

### Structure of Display

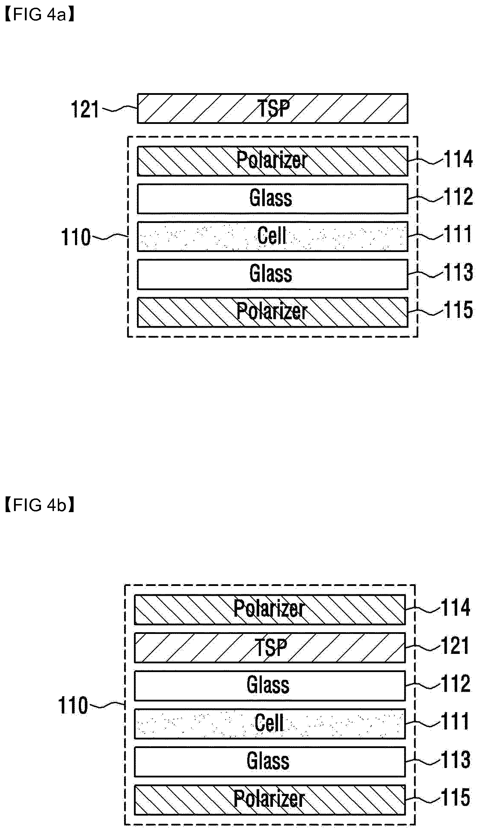

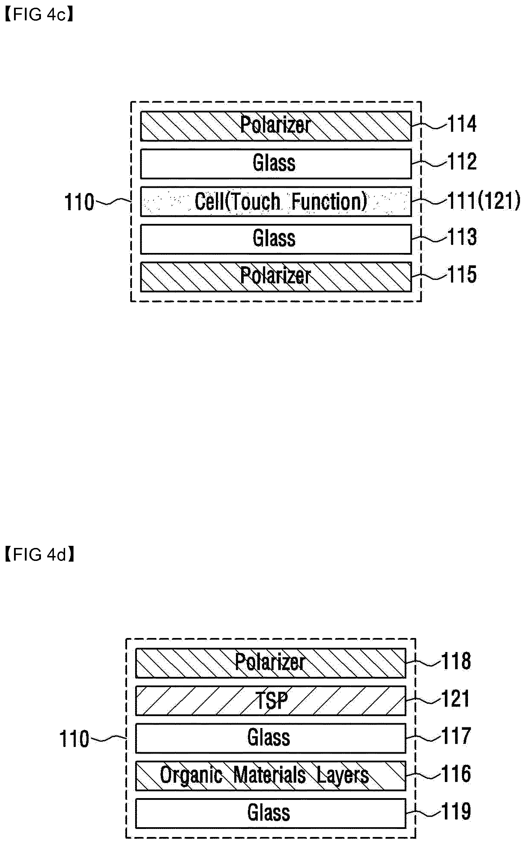

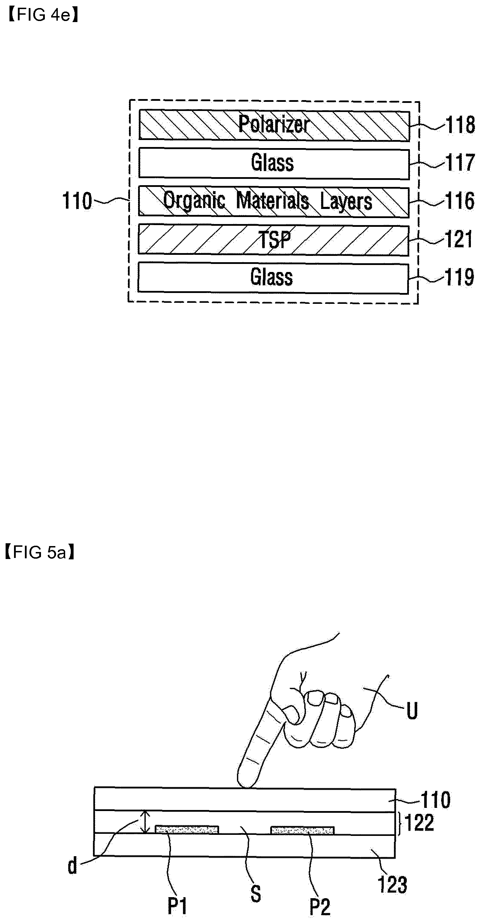

Figs. 4a to 4e are views showing the structure of the display 110 included in the touch screen 100 of the mobile terminal 1000 according to the embodiment of the present invention. Figs. 4a to 4e show various layer structures of the display 110 and the touch sensor panel 121 of Fig. 2. Specifically, Figs. 4a to 4c show the display 110 using an LCD panel. Figs. 4d and 4e show the display 110 using an OLED panel.

As shown in Figs. 4a to 4c, the LCD panel may include a liquid crystal layer 111 including a liquid crystal cell, a first glass layer 112 and a second glass layer 113 which are disposed on both sides of the liquid crystal layer 111 and include electrodes, a first polarizer layer 114 formed on a side of the first glass layer 112 in a direction facing the liquid crystal layer 111, and a second polarizer layer 115 formed on a side of the second glass layer 113 in the direction facing the liquid crystal layer 111. Here, the first glass layer 112 may be color filter glass, and the second glass layer 113 may be TFT glass. It is clear to those skilled in the art that the LCD panel may further include other configurations for the purpose of performing the displaying function and may be transformed.

Fig. 4a shows that the touch sensor panel 121 is disposed outside the display 110. Here, the surface of the mobile terminal 1000 where the touch occurs may be the surface of the touch sensor panel 121. Specifically, the user's touch may occur on the top surface of the touch sensor panel 121. Also, according to the embodiment, the touch surface of the mobile terminal 1000 may be the outer surface of the display 110. In Fig. 4a, the bottom surface of the second polarizer layer 115 of the display 110 is able to function as the touch surface. Here, in order to protect the display 110, the bottom surface of the display 110 may be covered with a cover layer (not shown) like glass.

Figs. 4b and 4c show that the touch sensor panel 121 is disposed inside the display panel 110. In Fig. 4b, the touch sensor panel 121 for detecting the touch position is disposed between the first glass layer 112 and the first polarizer layer 114. Here, the touch surface of the mobile terminal 1000 is the outer surface of the display 110. The top surface or bottom surface of the layer structure shown in Fig. 4b may be the touch surface of the mobile terminal 1000.

In Fig. 4c, the touch sensor panel 121 for detecting the touch position is included within the liquid crystal layer 111. Here, the touch surface of the mobile terminal 1000 is the outer surface of the display 110. The top surface or bottom surface of the layer structure shown in Fig. 4c may be the touch surface. In Figs. 4b and 4c, the top surface or bottom surface of the display 110, which can be the touch surface, may be covered with a cover layer (not shown) like glass.

As shown in Figs. 4d and 4e, the OLED panel includes a first polarizer layer 118, a first glass layer 117, an organic material layer 116, and a second glass layer 119. Here, the first glass layer 117 may be made of encapsulation glass. The second glass layer 119 may be made of TFT glass. However, there is no limitation to this.

Also, the organic material layer 116 may include a hole injection layer (HIL), a hole transport layer (HTL), an electron injection layer (EIL), an electron transport layer (ETL), and an light-emitting layer (EML). The HIL injects electron holes and is made of a material such as CuPc, etc. The HTL functions to move the injected electron holes and mainly is made of a material having a good hole mobility. Arylamine, TPD, and the like may be used as the HTL. The EIL and ETL inject and transport electrons. The injected electrons and electron holes are combined in the EML and emit light. The EML represents the color of the emitted light and is composed of a host determining the lifespan of the organic matter and an impurity (dopant) determining the color sense and efficiency. This just describes the basic structure of the organic material layer 280 include in the OLED panel. The present invention is not limited to the layer structure or material, etc., of the organic material layer 116.

The organic material layer 116 is inserted between an anode (not shown) and a cathode (not shown). When the TFT becomes an on-state, a driving current is applied to the anode and the electron holes are injected, and the electrons are injected to the cathode. Then, the electron holes and electrons move to the organic material layer 116 and emit the light.

In Fig. 4d, the touch sensor panel 121 is located between the first polarizer layer 118 and the first glass layer 117. In Fig. 4e, the touch sensor panel 121 is located between the organic material layer 116 and the second glass layer 119.

The first glass layer 117 may be made of encapsulation glass. The second glass layer 119 may be made of TFT glass.

The OLED panel is a self-light emitting display panel which uses a principle where, when current flows through a fluorescent or phosphorescent organic thin film and then electrons and electron holes are combined in the organic material layer, so that light is generated. The organic matter constituting the light emitting layer determines the color of the light.

Specifically, the OLED uses a principle in which when electricity flows and an organic matter is applied on glass or plastic, the organic matter emits light. That is, the principle is that electron holes and electrons are injected into the anode and cathode of the organic matter respectively and are recombined in the light emitting layer, so that a high energy exciton is generated and the exciton releases the energy while falling down to a low energy state and then light with a particular wavelength is generated. Here, the color of the light is changed according to the organic matter of the light emitting layer.

The OLED includes a line-driven passive-matrix organic light-emitting diode (PM-OLED) and an individual driven active-matrix organic light-emitting diode (AM-OLED) in accordance with the operating characteristics of a pixel constituting a pixel matrix. None of them require a backlight. Therefore, the OLED enables a very thin display to be implemented, has a constant contrast ratio according to an angle and obtains a good color reproductivity depending on a temperature. Also, it is very economical in that non-driven pixel does not consume power.

In terms of operation, the PM-OLED emits light only during a scanning time at a high current, and the AM-OLED maintains a light emitting state only during a frame time at a low current. Therefore, the AM-OLED has a resolution higher than that of the PM-OLED and is advantageous for driving a large area display panel and consumes low power. Also, a thin film transistor (TFT) is embedded in the AM-OLED, and thus, each component can be individually controlled, so that it is easy to implement a delicate screen.

### 3D Touch Detection

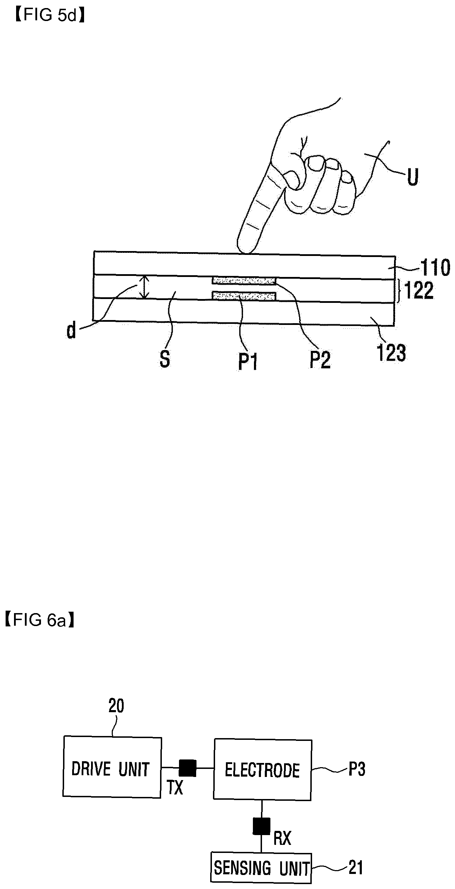

Figs. 5a to 5d and 6a to 6c are views for describing the structure and operation of the touch input unit 120 of the mobile terminal 1000 according to the embodiment of the present invention. Figs. 5a to 5d and 6a to 6c show the operation and detection method of the pressure detection module 122 of Fig. 2.

Figs. 5a to 5d show a method in which the pressure detection module 122 detects whether the 3D touch has occurred or not and/or the strength of the 3D touch on the basis of the mutual capacitance between pressure electrodes.

As shown in Fig. 5a, a spacer layer S may be disposed between the display 110 and the substrate 123. Pressure electrodes P1 and P2 disposed according to the embodiment shown in Fig. 5a may be disposed on the substrate 123 side.

The pressure detection module 122 may include the first electrode P1 and the second electrode P2 as pressure electrodes for pressure detection. Here, any one of the first electrode P1 and the second electrode P2 may be the drive electrode, and the other may be the receiving electrode. A drive signal is applied to the drive electrode, and a sensing signal is obtained through the receiving electrode. When voltage is applied, the mutual capacitance Cm is generated between the first electrode P1 and the second electrode P2.

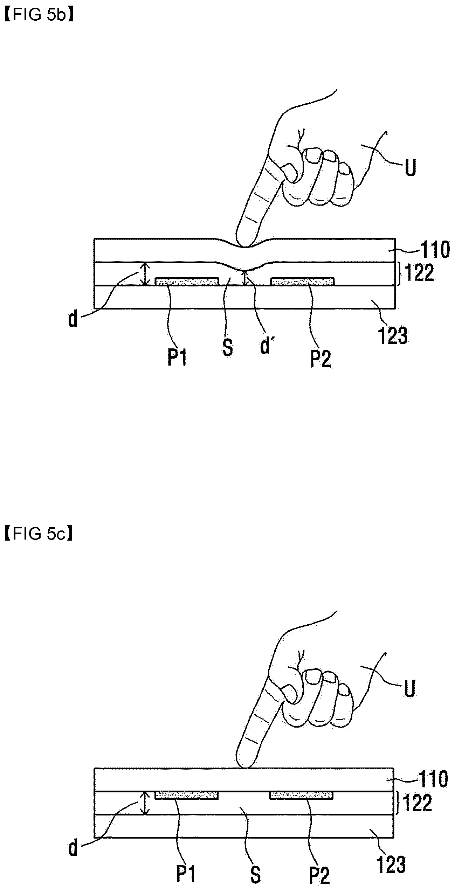

Fig. 5b shows that a 3D touch, i.e., a touch having a pressure is applied to the touch screen 100 shown in Fig. 5a. The bottom surface of the display 110 may have a ground potential in order to shield the noise. When the 3D touch with a pressure having a magnitude greater than a predetermined magnitude is applied to the surface of the touch screen 100 by the object U, the touch sensor panel 121 and the display 110 may be bent. As a result, a distance "d" between a ground potential surface, i.e., the reference potential layer and the two pressure electrodes P1 and P2 is reduced to " d' ". As a result, a fringing capacitance is absorbed in the bottom surface of the display 110, so that the mutual capacitance between the first electrode P1 and the second electrode P2 is reduced. By using this, the magnitude of the touch pressure can be calculated by obtaining the reduction amount of the mutual capacitance from the sensing signal obtained through the receiving electrode.

Fig. 5c shows the configuration of the pressure detection module 122 according to another embodiment of the present invention. In the electrode arrangement shown in Fig. 5c, the pressure electrodes P1 and P2 are disposed on the display 110 side between the display 110 and the substrate 123

The substrate 123 as the reference potential layer may have a ground potential. Therefore, as the 3D touch occurs, the distance " d " between the substrate 123 and the pressure electrodes P1 and P2 is reduced to " d' ". Consequently, this causes the change of the mutual capacitance between the first electrode P1 and the second electrode P2.

Fig. 5d shows the configuration of the pressure detection module 122 according to further another embodiment of the present invention. As shown in Fig. 5d, any one of the first electrode P1 and the second electrode P2 may be formed on the substrate 123, and the other may be formed under the display 110. Fig. 5d shows that the first electrode P1 is formed on the substrate 123 and the second electrode P2 is formed under the display 110. Further, the positions of the first electrode P1 and the second electrode P2 can be replaced with each other.

The principle of the structure of Fig. 5d is the same as that described above. That is, when the 3D touch is applied to the surface of the touch screen 100 by the object U, the bending occurs and the distance "d" between the first electrode P1 and the second electrode P2 is reduced to " d' ". Accordingly, the mutual capacitance between the first electrode P1 and the second electrode P2 is changed. Therefore, the magnitude of the touch pressure can be calculated by obtaining the reduction amount of the mutual capacitance from the sensing signal obtained through the receiving electrode.

Unlike the foregoing, whether the 3D touch has occurred or not and the strength of the 3D touch can be detected based on the self-capacitance of the pressure electrode. Figs. 6a to 6c show a method in which the pressure detection module 122 detects whether the 3D touch has occurred or not and/or the strength of the 3D touch on the basis of the self-capacitance between pressure electrodes.

The pressure detection module 122 for detecting the change amount of the self-capacitance uses a pressure electrode P3 formed under the display 110. When a drive signal is applied to the pressure electrode P3, the pressure detection module receives a signal including information on the change amount of the self-capacitance, and detects whether the 3D touch has occurred or not and/or the strength of the 3D touch.

The drive unit 20 applies a drive signal to the pressure electrode P3 and the sensing unit 21 measures a capacitance between the pressure electrode P3 and the reference potential layer 123 (e.g., the substrate) having a reference potential through the pressure electrode P3, thereby detecting whether the 3D touch has occurred or not and/or the strength of the 3D touch.

The drive unit 20 may include, for example, a clock generator (not shown) and a buffer to generate a drive signal in the form of a pulse and to apply the generated drive signal to the pressure electrode P3. However, this is merely an example, and the drive unit can be implemented by means of various elements, and the shape of the drive signal can be variously changed.

The drive unit 20 and the sensing unit 21 may be implemented as an integrated circuit or may be formed on a single chip. The drive unit 20 and the sensing unit 21 may constitute a pressure detector.

In order that the capacitance change amount is easily detected between the pressure electrode P3 and the reference potential layer 123, the pressure electrode P3 may be formed such that there is a larger facing surface between the pressure electrode P3 and the reference potential layer 123. For example, the pressure electrode P3 may be formed in a plate-like pattern. With regard to the detection of the touch pressure in the self-capacitance type method, here, one pressure electrode P3 is taken as an example for description. However, the plurality of electrodes are included and a plurality of channels are constituted, so that it is possible to configure that the magnitude of multi pressure can be detected according to multi touch.

The self-capacitance of the pressure electrode P3 is changed by the change of the distance between the pressure electrode p3 and the reference potential layer 123. Then, the sensing unit 21 detects information on the capacitance change, and thus detects whether the 3D touch has occurred or not and/or the strength of the 3D touch.

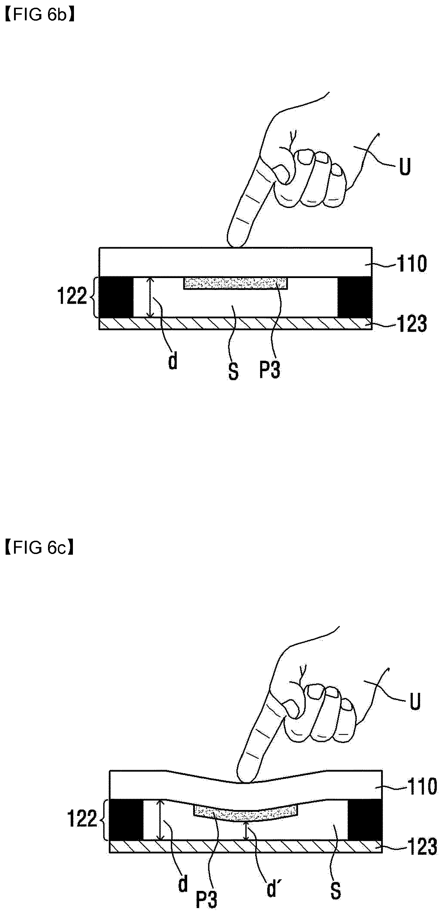

Fig. 6b shows the layer structure of the pressure detection module 122 for detecting the 3D touch by using the above-described self-capacitance change amount. As shown in Fig. 6b, the pressure electrode P3 is disposed apart from the reference potential layer 123 by a predetermined distance "d". Here, a material which is deformable by the pressure applied by the object U may be disposed between the pressure electrode P3 and the reference potential layer 123. For instance, the deformable material disposed between the pressure electrode P3 and the reference potential layer 123 may be air, dielectrics, an elastic body and/or a shock absorbing material.

When the object U applies the 3D touch with a pressure having a magnitude greater than a predetermined magnitude to the touch surface, the pressure electrode P3 and the reference potential layer 123 become close to each other by the applied pressure, and the spaced distance "d" is reduced.

Fig. 6c shows that a pressure is applied by the object U and the touch surface is bent downward. As the distance between the pressure electrode P3 and the reference potential layer 123 is reduced from "d" to " d' ", the self-capacitance is changed. Specifically, the self-capacitance generated between the pressure electrode P3 and the reference potential layer 123 is increased. Whether or not the thus generated self-capacitance is changed and the change amount of the thus generated self-capacitance are measured by the sensing unit 21, thereby determining whether the 3D touch has occurred or not and/or the strength of the 3D touch.

### Mode Setting Unit

The control unit 500 of the mobile terminal 1000 according to the embodiment of the present invention controls the camera unit 200 to photograph an image in a first photographing mode among a plurality of photographing modes. The image obtained by the camera unit 200 is displayed on the touch screen 100 in real time.

Here, when the object U such as a user's finger, stylus, etc., applies a 3D touch to the touch screen 100, the control unit 500 determines the intensity of the pressure applied by the 3D touch and determines whether the intensity is equal to or greater than a predetermined magnitude. If the intensity is equal to or greater than a predetermined magnitude, the control unit 500 switches the mode to a second photographing mode and controls the camera unit 200 to photograph an image.

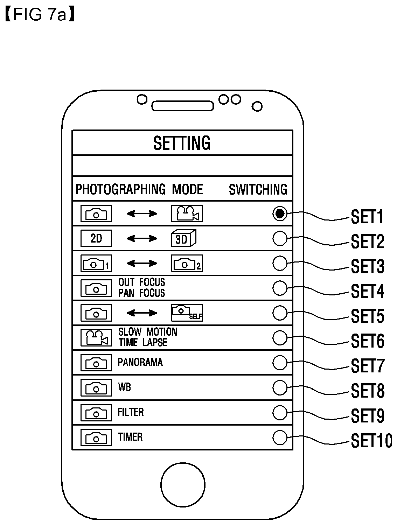

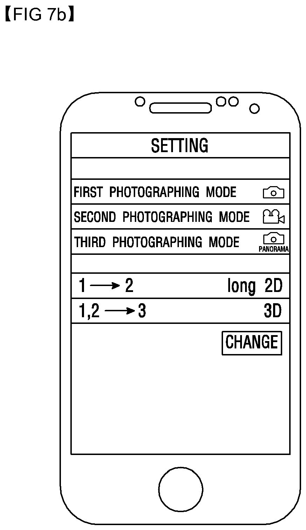

Here, the first photographing mode and the second photographing mode can be set in advance by a user input. Figs. 7a and 7b show a user interface for setting the photographing mode.

A setting menu may include switching between the picture photographing mode for photographing a still image and the video photographing mode for photographing a dynamic image (SET1), switching between the 2D photographing mode and the 3D photographing (SET2), switching between different specification camera modes (SET3), switching to the depth-of-field control mode (SET4), switching between the front camera mode and the rear camera mode (SET5), switching between the high speed photographing mode and the low speed photographing mode (SET6), switching to the panoramic photographing mode (SET7), switching to the white balance adjustment mode (SET8), switching to the filter application mode (SET9), and switching to the timer photographing mode (SET10), etc.

The setting menu may include other switching modes as well as the above-described configurations (SET1 to SET10). Fig. 7a shows a radio button type selection method. Alternatively, the setting menu can receive the user input in other forms such as a check box, a scroll bar, a list box, etc.

In addition, unlike the foregoing, the photographing mode may be switched according to the user input. For example, when the first photographing mode is set to the depth-of-field control mode and the second photographing mode is set to the panoramic photographing mode, the camera unit is operated in the depth-of-field control mode first. When the 3D touch with a pressure having a magnitude greater than a predetermined magnitude is applied, the photographing mode may be switched from the depth-of-field control mode to the panoramic photographing mode.

That is, the above configurations (SET1 to SET10) are merely examples, and the photographing mode can be switched by any combination of them.

Meanwhile, although the above description refers to the switching between two photographing modes, a larger number of photographing modes can be switched. For example, as shown in Fig. 7b, when the first photographing mode, the second photographing mode, and the third photographing mode are set, the photographing mode can be sequentially switched every time when the 3D touch with a pressure having a magnitude greater than a predetermined magnitude is applied.

Also, the photographing mode may be switched by using both the 2D touch and the 3D touch or based on the touch time. For example, when the 2D touch is continued for two seconds or more, the photographing mode is switched from the first photographing mode to the second photographing mode, and when the 3D touch is applied, the photographing mode is switched from the first photographing mode to the third photographing mode. A photographing mode switching condition (the touch type (2D and 3D) or touch time) can be also set by the user input through the touch screen 100.

### Picture Photographing Mode ↔ Video Photographing Mode

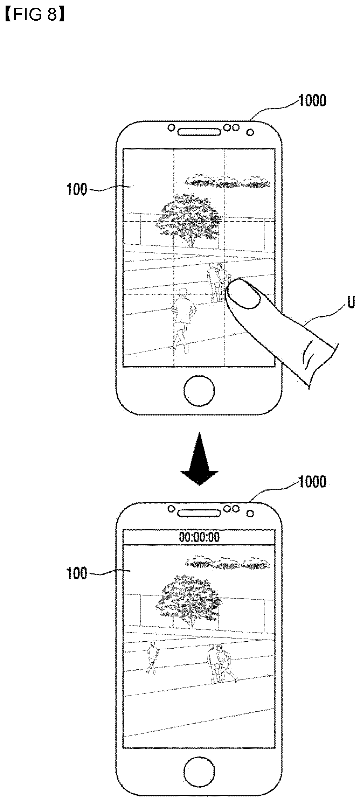

Fig. 8 is a view showing a method for switching the photographing modes in accordance with the first embodiment in the mobile terminal 1000 according to the embodiment of the present invention, that is to say, a switching method between the picture photographing mode and the video photographing mode. In this embodiment, the photographing mode switching method may be set to SET1 of Fig. 7a on the basis of the user input through the touch screen 100.

As shown in Fig. 8, in the mobile terminal 1000 operating in the picture photographing mode, the touch screen 100 displays an image photographed by the camera unit 200. The user performs photographing while checking the image displayed on the touch screen 100 in real time.

While the photographing is performed in the picture photographing mode, the control unit 500 continuously checks whether the 3D touch of the user is input or not.

The 3D touch refers to a touch with a pressure having a magnitude greater than a predetermined magnitude. If the 3D touch is detected in the manner described in Figs. 5a to 5d and 6a to 6c, the 3D touch means a touch having a sufficient pressure for the surface of the touch screen to be bent by a user's touch applied to the touch screen surface.

Alternatively, if the mobile terminal 1000 senses the 3D touch by using a separate pressure sensor (e.g., a piezoelectric sensor, a force sensor, or the like), the 3D touch means a touch allowing the separate pressure sensor to sense that a pressure having a predetermined magnitude is applied to the touch screen.

When it is determined that the 3D touch is input, the control unit 500 controls the camera unit 200 to operate in the second photographing mode on the basis of the photographing mode set in the mode setting unit 300.

In the embodiment of Fig. 8, since the second photographing mode is the video photographing mode for photographing a dynamic image, the photographing mode is switched from the picture photographing mode to the video photographing mode. The control unit 500 can display various types of information (e.g., photographing time) required for video photographing on the touch screen 100.

Regarding a video photographing starting time, in the mobile terminal 1000 according to the embodiment of the present invention, after the photographing mode is switched to the video photographing mode by the 3D touch, the video photographing can be started at a point of time when the 3D touch is released. That is, the control unit 500 switches the photographing mode from the picture photographing mode to the video photographing mode at the time of inputting the 3D touch, and starts the video photographing at the time of releasing the 3D touch. Here, the end of the video photographing may be performed by the operation of the touch screen 100 by the user (e.g., pressing the end button).

In another embodiment, at the time of inputting the 3D touch, the video photographing can be started simultaneously when the photographing mode is switched from the picture photographing mode to the video photographing mode. After this, the video photographing may be ended at the time of releasing the 3D touch.

Meanwhile, when the 3D touch is released while the video photographing is performed after the photographing mode is switched to the video photographing mode, the photographing mode may be switched to the picture photographing mode again. The photographed video image may be stored in the memory 400 at a point of time when the photographing mode is switched to the picture photographing mode again.

### 2D Photographing Mode ↔ 3D Photographing Mode

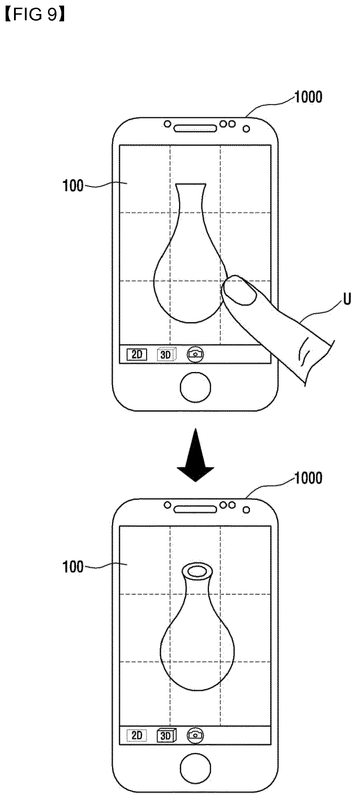

Fig. 9 is a view showing a method for switching the photographing modes in accordance with a second embodiment in the mobile terminal 1000 according to the embodiment of the present invention, that is to say, a switching method between the 2D (two dimensional) photographing mode and the 3D (three dimensional) photographing mode. In this embodiment, the photographing mode switching method may be set to SET2 of Fig. 7a on the basis of the user input through the touch screen 100.

In this embodiment, for photographing 3D images, the camera unit 200 may include a first camera which photographs a right eye image and a second camera which photographs a left eye image.

The first camera and the second camera may include a lens dedicated for 3D images and/or an image sensor which are/is optimized for photographing a right eye image and a left eye image. In order to generate a 3D image, the first camera and the second camera must be spaced apart from each other by a predetermined spaced distance. If the spaced distance of at least 10 Cm is required, the first camera and the second camera are positioned at the upper portion of the rear surface and the lower portion of the rear surface of the mobile terminal 1000, respectively, so that the spaced distance can be maximized.

The camera unit 200 may include the 3D image generator which performs image processing on a left eye image and a right eye image photographed by the first camera and the second camera and reconstructs a 3D image. Meanwhile, the display 110 of the touch screen 100 has a structure and function capable of displaying 3D images, which can be implemented by using various conventional 3D display manufacturing technologies. For the purpose of avoid making the subject matter of the present invention unclear, a detailed description of the 3D display will be omitted.

The control unit 500 controls the camera unit to photograph an image in the 2D photographing mode, and switches the photographing mode to the 3D photographing mode when the 3D touch is input. The user performs 3D photographing (obtains a right eye image and a left eye image) by operating the touch screen (e.g., touching a photographing button) while visually checking the image of a subject displayed on the touch screen 100. The obtained right eye image and left eye image are transmitted to the 3D image generator and are image-processed, and then generated as a 3D image.

The generated 3D image may be stored in the memory 400 or displayed on the touch screen 100. In addition, the touch screen 100 may display in a part of the screen whether the current photographing mode is the 2D photographing mode or the 3D photographing mode.

### First Camera Mode ↔ Second Camera Mode

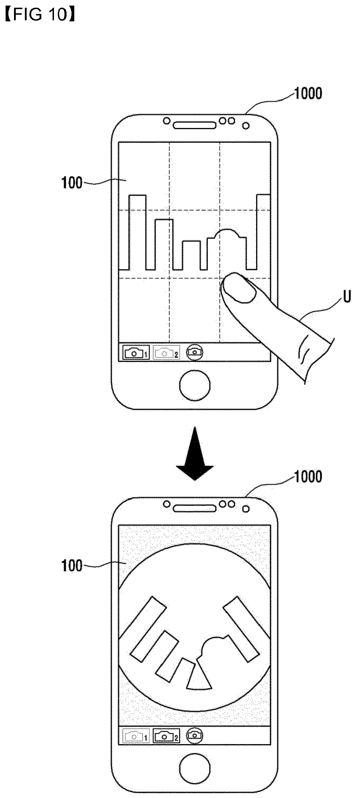

Fig. 10 is a view showing a method for switching the photographing modes in accordance with a third embodiment in the mobile terminal 1000 according to the embodiment of the present invention, that is to say, a switching method between a first camera mode and a second camera mode. In this embodiment, the photographing mode switching method may be set to SET3 of Fig. 7a on the basis of the user input through the touch screen 100.

The camera unit 200 may include a first camera and a second camera. One or more of the angle of view, the number of pixels, the shortest object distance, the ISO, the zoom magnification, and the minimum aperture value of the first and second cameras may be different from each other. The first camera and the second camera may be disposed on the front side of the mobile terminal 1000 or on the rear side of the mobile terminal 1000. Meanwhile, it can be considered that the first camera is disposed on the front side of the mobile terminal 1000 and the second camera is disposed on the rear side of the mobile terminal 1000.

The first camera and the second camera may have different angles of view. That is, the first camera and the second camera may include a wide angle lens having a wide angle of view of 60° to 80°, a telephoto lens having a narrow angle of view of 30° or less, a lens having a standard angle of view of 44° to 55°, or a fisheye lens having an angle of view of 180°.

The first camera and the second camera may have different numbers of pixels. That is, an image sensor (e.g., a CCD) provided in each of the first camera and the second camera may have millions to tens of millions of pixels. This is a factor for determining the resolution of the obtained image, and the user can select one of the first camera and the second camera to take a photograph in accordance with a required resolution.

The first camera and the second camera may have different shortest object distances. The shortest object distance means a distance from the image sensor of the camera, and may vary depending on the focal length. That is, since the first camera and the second camera have lenses having different focal lengths, they can have different shortest object distances. The user can select a camera having a smaller shortest object distance to obtain a desired image in order to obtain a close-up image.

The first camera and the second camera may have different ISOs. The ISO controls response to light when the image sensor receives the light. The higher the ISO, the brighter the picture. For example, a low-sensitivity ISO is suitable for photographing on sunny days or outdoors because the low-sensitivity ISO has its low noise and a low shutter speed, and a high-sensitivity ISO (e.g., ISO 400 or higher) is suitable for photographing in the dark room because the high-sensitivity ISO can increase the shutter speed. The user selects a camera having the ISO suitable for the photographing environment, thereby obtaining a high quality image.

The first camera and the second camera may have different zoom magnifications. The ratio of the longest focal length to the shortest focal length is called the magnification of a lens. The magnification of a lens is involved in the angle of view of the lens. The user selects a camera having an appropriate zoom magnification according to the distance to the image, thereby obtaining an image of a desired composition.

The first camera and the second camera may have different minimum aperture values. The smaller the aperture value is, the more the aperture is maximally opened. Therefore, a bright image can be obtained by using a lens having the smallest aperture value. Also, by reducing the aperture value, it is possible to maximize the out-focusing effect. The user selects a camera having an appropriate aperture value, thereby obtaining an image of a desired style.

In the embodiment shown in Fig. 10, the camera unit 200 includes a first camera having a standard lens and a second camera having a fisheye lens. When the 3D touch is input while the photographing is performed in the first camera mode, the photographing mode is switched from the first camera mode to the second camera mode.

Since the second camera of Fig. 10 includes the fisheye lens, an image photographed by the fisheye lens is displayed on the touch screen 100, and the image is obtained by operating the touch screen (e.g., touching a photographing button).

### Picture Photographing mode ↔ Depth-of-field Control Photographing Mode

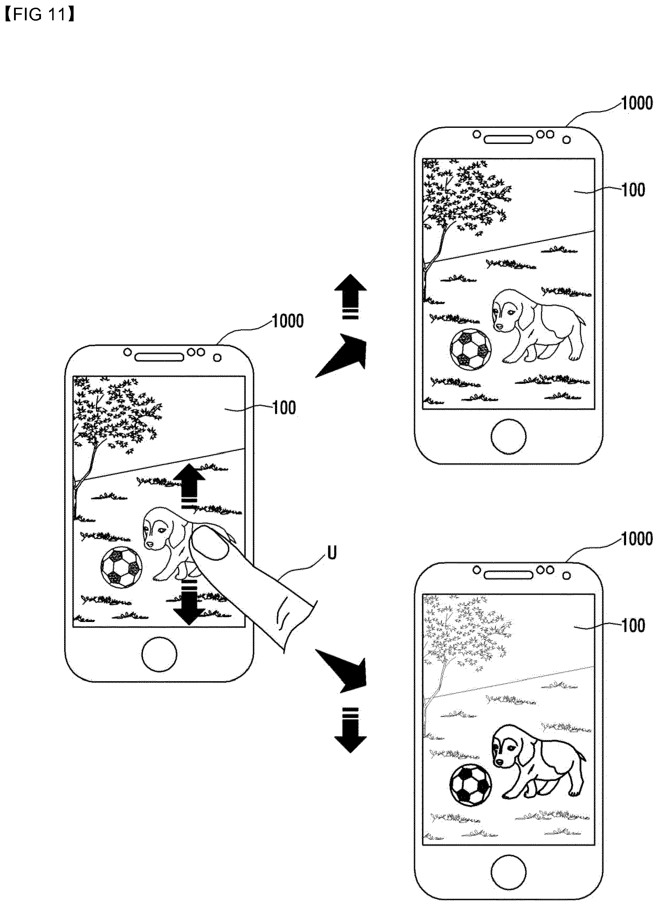

Fig. 11 is a view showing a method for switching the photographing modes in accordance with a fourth embodiment in the mobile terminal 1000 according to the embodiment of the present invention, that is, a switching method between the picture photographing mode and the depth-of-field control photographing mode. In this embodiment, the photographing mode switching method may be set to SET4 of Fig. 7a on the basis of the user input through the touch screen 100.

The depth of field refers to an area in which a focus of a subject is clearly captured. The wider the range in which focusing is performed, the more the depth-of-field increases, so that a pan-focus effect is obtained. The narrower the range in which focusing is performed, the more the depth-of-field decreases, so that an out-focus effect is obtained.

The depth-of-field can be adjusted by the aperture value or the focal length. When the aperture value is large, the aperture is much closed, and thus, the light amount is reduced and the depth-of-field increases, so that the pan-focus effect is obtained. When the aperture value is small, the aperture is much opened, and thus, the light amount is increased and the depth-of-field decreases, so that the out-focus effect is obtained. Therefore, in order to maximize the out-focus effect, the aperture value must be reduced to the maximum. Further, the longer the focal length, the greater the out-focus effect may be.

As shown in Fig. 11, when the 3D touch is input while the photographing is performed in the picture photographing mode, the control unit 500 switches the photographing mode from the picture photographing mode to the depth-of-field control photographing mode.

The control unit 500 may further determine movement information of the touch in order to select an out-focusing mode or a pan-focusing mode during photographing in the depth-of-field control photographing mode.

Specifically, as shown in Fig. 11, when the touch moves upward after the photographing mode is switched to the depth-of-field control photographing mode, the control unit 500 controls the camera unit to operate in the pan-focusing mode. When the touch moves downward, the control unit 500 controls the camera unit to operate in the out-focusing mode. In other words, when the touch moves upward, the depth-of-field is controlled to gradually decrease, and when the touch moves downward, the depth-of-field is controlled to gradually increase, and vice versa.

Meanwhile, in another embodiment, the depth-of-field can be controlled according to the strength of the 3D touch. In other words, the control unit 500 determines the pressure of the 3D touch, and when the pressure of the 3D touch increases, the depth-of-field is controlled to gradually decrease, and when the pressure of the 3D touch decreases, the depth-of-field is controlled to gradually increase, and vice versa.

Regarding the switching of the pan-focusing mode or the out-focusing mode, as described above, the camera unit 200 can switch the two modes by changing the aperture value or the focal length.

In another embodiment, when the 3D touch is applied, the photographing mode may be immediately switched from the picture photographing mode to the pan-focusing mode, may be immediately switched from the picture photographing mode to the out-focusing mode. The switching method can be set by the user input through the touch screen 100.

### Front Side Camera Mode ↔ Rear Side Camera Mode

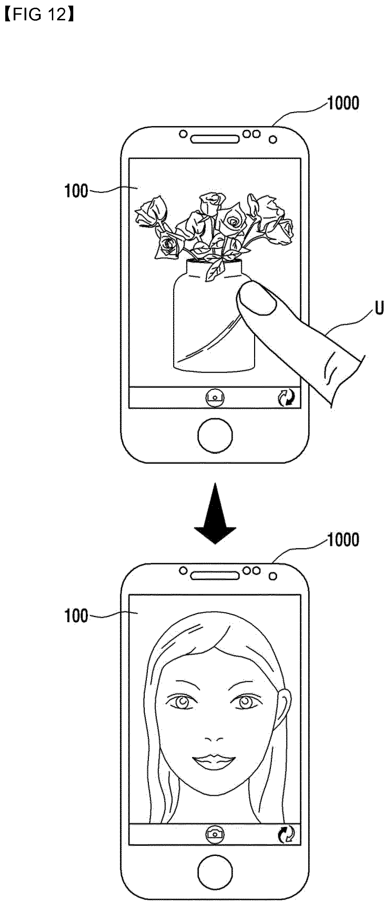

Fig. 12 is a view showing a method for switching the photographing modes in accordance with a fifth embodiment in the mobile terminal 1000 according to the embodiment of the present invention, that is to say, a switching method between the front camera mode and the rear camera mode. In this embodiment, the photographing mode switching method may be set to SET5 of Fig. 7a on the basis of the user input through the touch screen 100.

The camera unit 200 according to the embodiment of the present invention may include a rear side camera disposed on the rear side of the mobile terminal 1000 and a front side camera disposed on the front side of the mobile terminal 1000. The specifications of the rear side camera and the front side camera may be the same or different.

As shown in Fig. 12, when the 3D touch is input while photographing by using the rear side camera, the control unit 500 switches the photographing mode to the front camera mode. The front side camera is advantageous for self-photographing, that is, for taking a picture of the user himself/herself. When the photographing mode is switched to the front camera mode, the user can obtain the self-camera image by operating the touch screen 100 (e.g., touching a photographing button).

### Video Photographing Mode ↔ Speed Control Photographing Mode

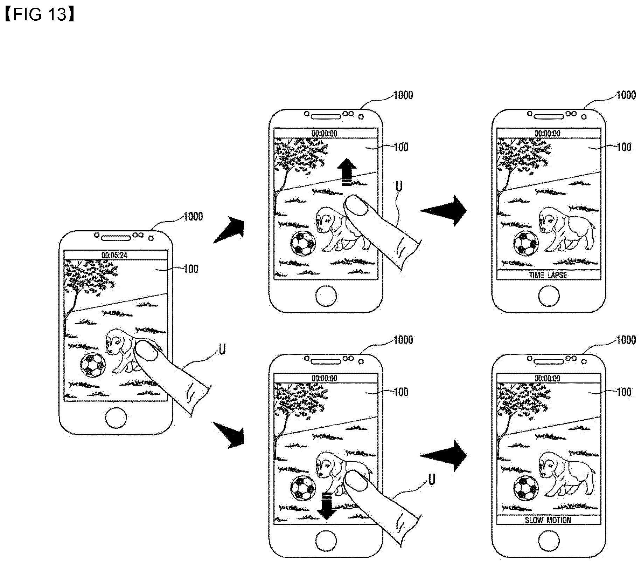

Fig. 13 is a view showing a method for switching the photographing modes in accordance with a sixth embodiment in the mobile terminal 1000 according to the embodiment of the present invention, that is to say, a switching method between the video photographing mode and the speed control photographing mode. In this embodiment, the photographing mode switching method may be set to SET6 of Fig. 7a on the basis of the user input through the touch screen 100.

Low-speed photographing refers to photographing at a speed lower than a standard speed and obtaining a smaller number of frames at a reference time. When the image obtained by the low speed photographing is reproduced again at the standard speed, the movement of the subject becomes faster, so that the sense of movement and speed are improved. This is also called time lapse technology.

High speed photographing refers to photographing at a speed higher than a standard speed and obtaining a larger number of frames at a reference time. When the image obtained by the high speed photographing is reproduced again at the standard speed, the movement of the subject becomes slower, so that the sense of movement and speed are considerably deteriorated. This is also called slow motion technology.

Here, the photographing speed (that is, the number of frames obtained at the reference time) can be input and set through the touch screen 100. For example, the user can set a frame interval to obtain frames such as 1/10 second, 1/2 second, 1 to 5 seconds, and so on.

In the embodiment of the present invention, when the 3D touch is input while the photographing is performed in the video photographing mode, the photographing mode is switched to the speed control photographing mode. The control unit 500 may switch the photographing mode to the low speed photographing mode or the high speed photographing mode at the time of inputting the 3D touch. Alternatively, when a predetermined period of time elapses after the 3D touch is input, the control unit 500 may switch the photographing mode to the low speed photographing mode or the high speed photographing mode.

Also, as shown in Fig. 13, the control unit 500 can select one of the low speed photographing mode and the high speed photographing mode on the basis of at least one of whether or not the 3D touch has occurred and the movement direction of the touch.

For example, when the touch moves upward (this may be the movement of the 2D touch or the 3D touch) after the 3D touch is applied, the control unit 500 may select the photographing mode as the low speed photographing mode for time lapse photographing.

In contrast to this, when the touch moves downward (this may be the movement of the 2D touch or the 3D touch) after the 3D touch is applied, the control unit 500 may select the photographing mode as the high speed photographing mode for slow motion photographing.

Meanwhile, in another embodiment, any one of the low speed photographing and the high speed photographing may be selected according to the strength of the 3D touch. That is, when the strength of the 3D touch is divided according to sections and the strength of the 3D touch, which corresponds to each of the sections is applied, any one of the low speed photographing and the high speed photographing may be selected. The control unit 500 can display the selected photographing mode on the touch screen 100.

### Picture Photographing Mode ↔ Panorama Photographing Mode

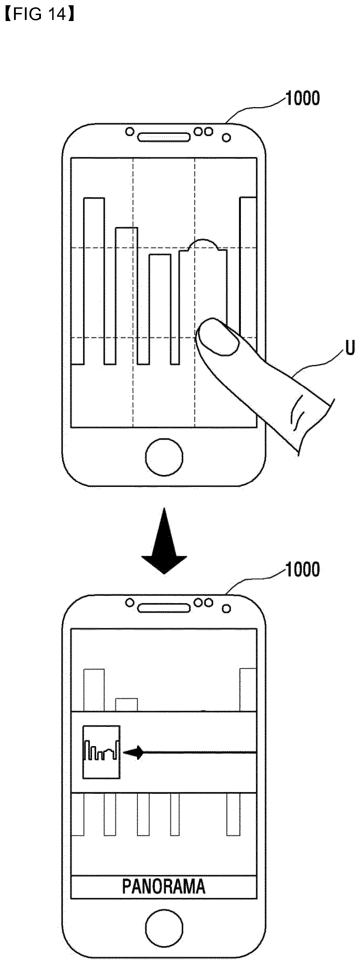

Fig. 14 is a view showing a method for switching the photographing modes in accordance with a seventh embodiment in the mobile terminal 1000 according to the embodiment of the present invention, that is to say, a switching method between the picture photographing mode and the panoramic photographing mode. In this embodiment, the photographing mode switching method may be set to SET7 of Fig. 7a on the basis of the user input through the touch screen 100.

Panoramic photographing refers to photographing in which a plurality of images obtained while moving the camera horizontally are reconstructed and one continuous image is obtained. In this embodiment, the camera unit 200 may further include an image constructor (not shown) for image-processing the obtained plurality of images and for reconstructing a panoramic image.

As shown in Fig. 14, when the 3D touch is input while the photographing is performed in the picture photographing mode, the control unit 500 switches the photographing mode from the picture photographing mode to the panoramic photographing mode.

Here, the touch screen 100 displays a guide line for guiding the user to move the camera in a particular direction. The user horizontally moves the mobile terminal 1000 in accordance with the guide line, and the camera unit 200 obtains an image at every predetermined time or at every predetermined interval while moving in the horizontal direction. It is preferable to set the predetermined time or the predetermined interval such that at least portions of the obtained image so as to overlap each other.

The image constructor (not shown) reconstructs the plurality of images to generate one panoramic image.

### Picture Photographing Mode ↔ White Balance Adjustment Mode

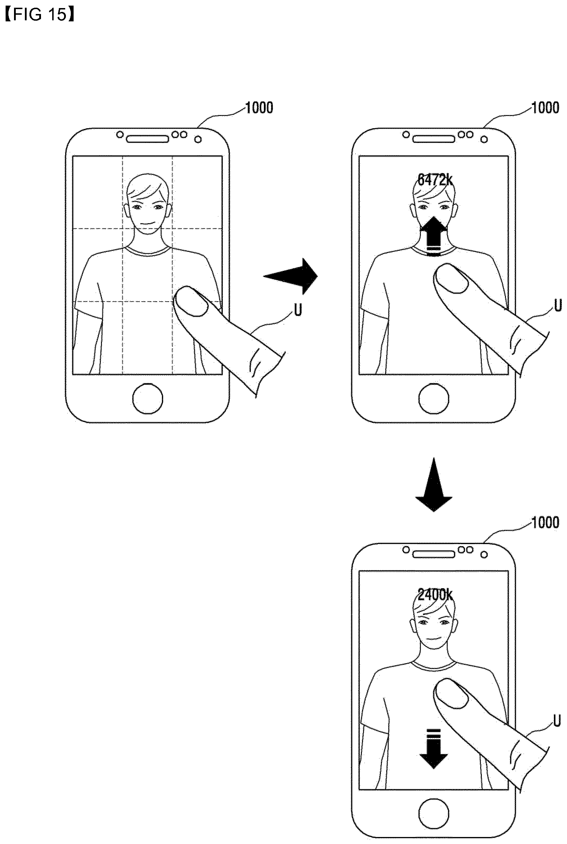

Fig. 15 is a view showing a method for switching the photographing modes in accordance with an eighth embodiment in the mobile terminal 1000 according to the embodiment of the present invention, that is to say, a switching method between the picture photographing mode and the white balance adjustment mode. In this embodiment, the photographing mode switching method may be set to SET8 of Fig. 7a on the basis of the user input through the touch screen 100.

A color temperature determines the color sense of the image to be displayed. When the color temperature is low, the image is reddish. When the color temperature is high, the image is bluish. Accordingly, a color sense which is completely different from the color sense sensed visually by human is displayed on the image, and white balance is used to correct the difference. This means that the gain is adjusted for each color (R, G, and B) to correct the color sense of the image in such a manner as to best match the color sense sensed visually by human. The white balance is manually adjusted by the user and automatically adjusted by detecting the photographing environment.

In this embodiment, when the 3D touch is applied while the photographing is performed in the picture photographing mode, the control unit 500 switches the photographing mode from the picture photographing mode to the white balance adjustment mode. In the white balance adjustment mode, the touch screen 100 can display the numerical value of the white balance.

The white balance adjustment may be made by the strength of the 3D touch. For example, when the strength of the 3D touch on the touch screen 100 is increased, the color temperature may be adjusted to be higher. When the strength of the 3D touch on the touch screen 100 is decreased, the color temperature may be adjusted to be lower.

In another embodiment, the white balance adjustment may be based on any one of the strength of the 3D touch and the movement direction of the touch. As shown in Fig. 15, when the 3D touch is applied and the touch position (the position of the 2D touch or the 3D touch) moves upward, the color temperature may be adjusted to increase, and when the touch position moves downward, the color temperature may be adjusted to decrease.

The touch screen 100 can display the change of the color temperature on the screen when the white balance is adjusted by a user operation.

### Picture Photographing Mode ↔ Filter Application Mode

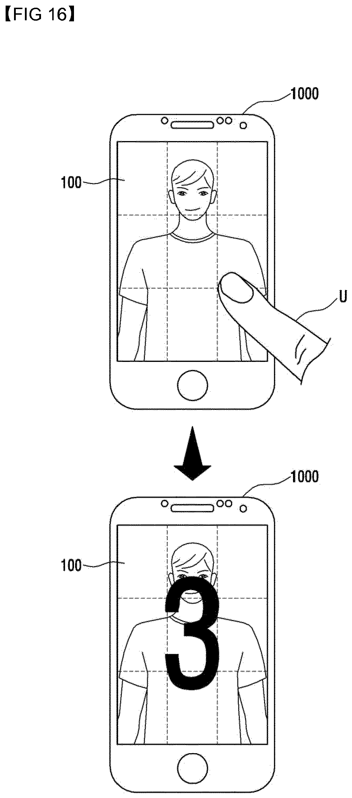

Fig. 16 is a view showing a method for switching the photographing modes in accordance with a ninth embodiment in the mobile terminal 1000 according to the embodiment of the present invention, that is to say, a switching method between the picture photographing mode and the filter application mode. In this embodiment, the photographing mode switching method may be set to SET9 of Fig. 7a on the basis of the user input through the touch screen 100.

In the mobile terminal 1000 according to the embodiment of the present invention, image filtering can be processed in a software manner. If the image is corrected or distorted by changing the color, tone, brightness, saturation, and white balance of the image obtained by the camera unit 200, the feeling and tone of the picture can be changed.

As shown in Fig. 16, when the 3D touch is applied while the photographing is performed in the picture photographing mode, an image to which various filtering have been applied can be displayed on the touch screen 100. Preferably, the touch screen 100 is divided as much as the number of applied filters, and the filtered image is displayed in each of the divided areas. The image displayed in each area is the image to which each filtering has been applied, and the user can visually check each filtered image and select his/her desired images.

The selection of the filtered image may be made by the operation of the touch screen 100 of the user. When the touch (2D touch or 3D touch) is moved to an area where a specific filtered image has been displayed and then the touch is released in the area, it is determined that the filtered image has been selected. The touch screen 100 can display the selected filtered image again on the full screen.

### Picture Photographing Mode ↔ Timer Photographing Mode

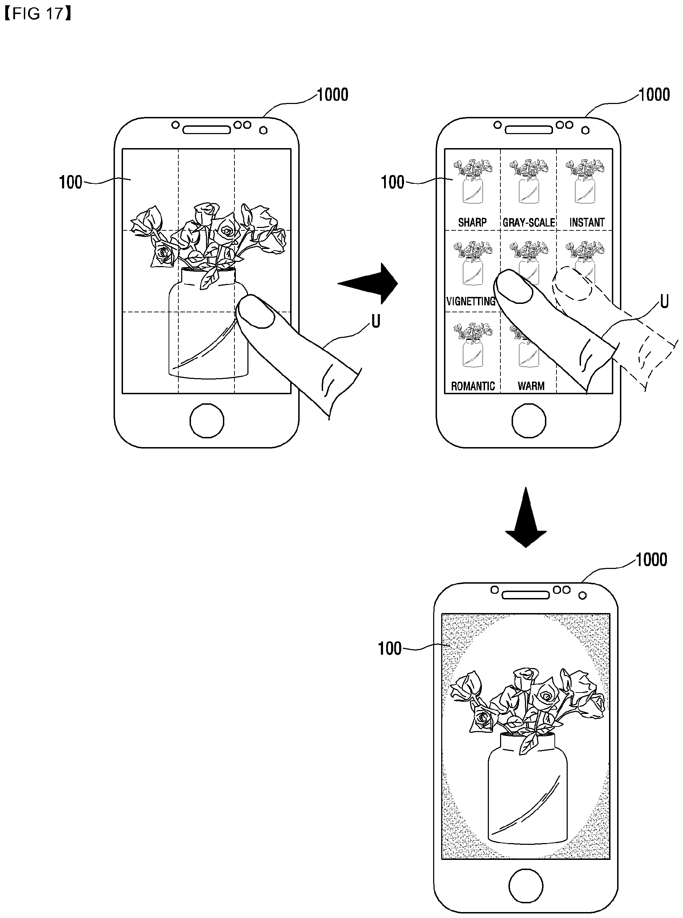

Fig. 17 is a view showing a method for switching the photographing modes in accordance with a tenth embodiment in the mobile terminal 1000 according to the embodiment of the present invention, that is to say, a switching method between the picture photographing mode and the timer photographing mode. In this embodiment, the photographing mode switching method may be set to SET10 of Fig. 7a on the basis of the user input through the touch screen 100.

When the 3D touch is input while the photographing is performed in the picture photographing mode, the control unit 500 switches the photographing mode to the timer photographing mode. The timer photographing mode is a mode in which an image is obtained after a predetermined time is counted after the photographing is started.

Here, the predetermined time may be set by the operation of the touch screen 100 of the user. In another embodiment, the predetermined time may be the time from when the photographing mode is switched to the timer photographing mode to when the 3D touch is released. For example, after the 3D touch is input and the photographing mode is switched to the timer photographing mode, when the 3D touch is released at a point of time when three seconds have elapsed, an image is obtained after three seconds. In this case, a counter for determining the predetermined time may be included.

Also, the touch screen 100 may display in real time the predetermined time or the change of time which is counted.

As shown in Figs. 8 to 16, since the mobile terminal 1000 according to the embodiment of the present invention uses the 3D touch with a predetermined magnitude as well as the 2D touch, it provides easier and various switching methods. However, Figs. 8 to 16 are merely examples for understanding, and the photographing mode can be switched in a manner different from that of the above-mentioned embodiment without departing from the essential features of the present invention.

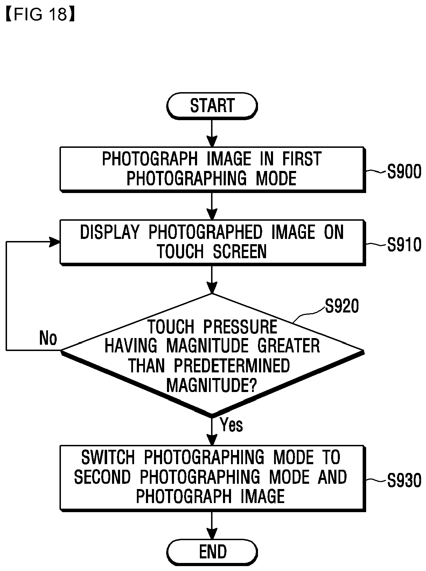

FIG. 18 is a flowchart showing the method for switching the photographing modes according to the embodiment of the present invention.

The photographing mode switching method according to the embodiment of the present invention can be used in the mobile terminal 1000 including the camera unit 200 for photographing an image and the touch screen 100 for detecting the touch pressure as described above.

First, an image is photographed in the first photographing mode (S900), and the photographed image is displayed on the touch screen (S910). Then, it is determined whether a touch pressure having a magnitude greater than a predetermined magnitude is applied to the touch screen 100 or not (S920). If it is determined that the touch pressure is applied, the photographing mode is switched from the first photographing mode to the second photographing mode, and the image is photographed (S930) .

Here, when the first photographing mode is the picture photographing mode for photographing a still image, the second photographing mode may be one of the video photographing mode for photographing a dynamic image, the out-focusing photographing mode for photographing an out-focusing image, the panoramic photographing mode for photographing a panoramic image, the white balance adjustment mode capable of adjusting white balance, the filter application mode for generating a filtered image, and the timer photographing mode for timer photographing.

When the first photographing mode is the video photographing mode for photographing a dynamic image, the second photographing mode may be the picture photographing mode for photographing a still image or the speed control photographing mode for high speed photographing or low speed photographing.

Meanwhile, the camera unit 200 includes two cameras. When the first photographing mode is the 2D photographing mode for photographing a 2D image, the second photographing mode may be the 3D photographing mode for photographing a 3D image. When the first photographing mode is the front camera mode for front camera photographing, the second photographing mode may be the rear camera mode for rear camera photographing. When the first photographing mode is the mode for photographing by the first camera, the second photographing mode may be the mode for photographing by the second camera.

The foregoing is based on the operation performed in the second photographing mode after the first photographing mode is switched to the second photographing mode. Further, after the photographing mode is switched to the second photographing mode by the input of the 3D touch, the photographing mode may be switched to the first photographing mode again at the time of releasing the 3D touch.

The release of the above-mentioned 3D touch with a pressure having a magnitude greater than a predetermined magnitude may mean the touch between the object (the user's finger, etc.) and the touch screen 100 is released, or may mean the pressure (force) of the 3D touch is reduced to less than a predetermined magnitude while the touch between the object and the touch screen 100 is maintained.

The features, structures and effects and the like described in the embodiments are included in at least one embodiment of the present invention and are not necessarily limited to one embodiment. Furthermore, the features, structures, effects and the like provided in each embodiment can be combined, changed, modified, converted, replaced, added, transformed, and applied by those skilled in the art to which the embodiments belong. Therefore, contents related to the combination, change, modification, conversion, replacement, and addition should be construed to be included in the scope of the present invention without departing from the spirit of the present invention.

### INDUSTRIAL APPLICABILITY

Since the mobile terminal and the method for switching the photographing modes use a control method based on a touch pressure, it is possible to very easily switching various photographing modes including the picture photographing mode and the video photographing mode.

## Claims

1. A mobile terminal comprising:
a touch screen which detects touch information comprising a touch pressure;
a camera unit which is operable in a plurality of photographing modes;
a control unit which, when a touch pressure having a magnitude greater than a predetermined magnitude is applied to the touch screen while photographing a subject in a first photographing mode among the plurality of photographing modes, switches the photographing mode to a second photographing mode and controls the subject to be photographed.

2. The mobile terminal of claim 1, wherein, when the touch pressure is released, the control unit switches the photographing mode to the first photographing mode again and controls the subject to be photographed.

3. The mobile terminal of claim 1, further comprising a mode setting unit which sets the first photographing mode and the second photographing mode on the basis of a touch input through the touch screen,
wherein the control unit controls switching of the photographing modes on the basis of the first photographing mode and the second photographing mode which are set in the mode setting unit.

4. The mobile terminal of claim 1, further comprising a memory which stores an image obtained by the camera unit, and wherein the control unit controls the image stored in the memory to be displayed on the touch screen.

5. The mobile terminal of claim 1, wherein the first photographing mode is a picture photographing mode for photographing a still image, and wherein the second photographing mode is a video photographing mode for photographing a dynamic image.

6. The mobile terminal of claim 5, wherein the control unit controls video photographing to be started at a point of time when the touch pressure is released.

7. The mobile terminal of claim 5, wherein the control unit controls the video photographing to be started at a point of time when the photographing mode is switched to the video photographing mode, and controls the video photographing to be ended when the touch pressure is released.

8. The mobile terminal of claim 7, wherein the control unit controls the photographed video image to be stored when the touch pressure is released, and then switches the photographing mode to the first photographing mode again.

9. The mobile terminal of claim 1, wherein the camera unit comprises a first camera and a second camera which are spaced by a predetermined distance from each other, wherein the first photographing mode is a 2D photographing mode for photographing a 2D image by using one of the first camera and the second camera, and wherein the second photographing mode is a 3D photographing mode for photographing a 3D image by using the first camera and the second camera.

10. The mobile terminal of claim 9, wherein the camera unit further comprises a 3D image generator which reconstructs a 3D image by using the image obtained by the first camera and the second camera.

11. The mobile terminal of claim 1, wherein the camera unit comprises a first camera and a second camera, and one or more of an angle of view, a minimum aperture value, a shortest object distance, a zoom magnification, the number of pixels, and ISO of the first and second cameras are different from each other, wherein the first photographing mode is a mode for photographing an image by using the first camera, and wherein the second photographing mode is a mode for photographing an image by using the second camera.

12. The mobile terminal of claim 1, wherein the camera unit comprises a front side camera disposed on a front side of the mobile terminal and a rear side camera disposed on a rear side of the mobile terminal, wherein the first photographing mode is a front camera mode for photographing by using the front side camera, and wherein the second photographing mode is a rear camera mode for photographing by using the rear side camera.

13. The mobile terminal of claim 1, wherein the first photographing mode is a picture photographing mode for photographing a still image, wherein the second photographing mode is a depth-of-field control mode for pan-focusing photographing or out-focusing photographing, and wherein, when the photographing mode is switched to the second photographing mode, the camera unit photographs the subject by controlling a depth-of-field on the basis of at least one of an aperture value and a focal length.

14. The mobile terminal of claim 13, wherein the control unit controls a pan-focusing image or an out-focusing image of the subject to be photographed, on the basis of at least one of the touch pressure and a movement direction of the touch.

15. The mobile terminal of claim 13, wherein the control unit controls the depth-of-field of the image to gradually decrease when an intensity of the touch pressure increases, and wherein the control unit controls the depth-of-field of the image to gradually increase when the intensity of the touch pressure decreases.

16. The mobile terminal of claim 1, wherein the first photographing mode is a video photographing mode for photographing a dynamic image, wherein the second photographing mode is a speed control photographing mode for high speed photographing or low speed photographing, and wherein the control unit controls the subject to be photographed at a low speed or at a high speed by controlling the number of frames obtained according to time.

17. The mobile terminal of claim 16, wherein the control unit selects one of the low speed photographing and the high speed photographing on the basis of at least one of an intensity of the touch pressure and a movement direction of the touch.

18. The mobile terminal of claim 1, wherein the first photographing mode is a picture photographing mode for photographing a still image, and wherein the second photographing mode is a panoramic photographing mode for photographing a panoramic image.

19. The mobile terminal of claim 18, wherein, when the photographing mode is switched to the second photographing mode, the touch screen displays a guide line for guiding a movement direction of the camera.

20. The mobile terminal of claim 18, wherein the control unit controls panoramic photographing to be started at a point of time when the touch pressure is released.

21. The mobile terminal of claim 18, wherein the control unit controls the panoramic photographing to be started at a point of time when the photographing mode is switched to the panoramic photographing mode, and controls the panoramic photographing to be ended at a point of time when the touch pressure is released.

22. The mobile terminal of claim 1, wherein the second photographing mode is a white balance adjustment mode for controlling a color temperature of an image, and wherein the control unit controls the color temperature of the image to be controlled on the basis of at least one of an intensity of the touch pressure and a movement direction of the touch.

23. The mobile terminal of claim 22, wherein the touch screen displays a change of a numerical value of the color temperature based on at least one of the intensity of the touch pressure and the movement of the touch.

24. The mobile terminal of claim 1, wherein the second photographing mode is a timer photographing mode for photographing an image after a predetermined time is counted, and wherein the control unit controls the image to be obtained after the predetermined time is counted after the photographing is started.

25. The mobile terminal of claim 24, wherein the predetermined time is a time from when the photographing mode is switched to the timer photographing mode to when the touch pressure is released, and wherein the control unit controls the image to be obtained at a point of time when the touch pressure is released.

26. The mobile terminal of claim 24, wherein the touch screen displays the predetermined time or a change of time which is counted.

27. The mobile terminal of claim 1, wherein the second photographing mode is a filter application mode for obtaining a filtered image, wherein, when the photographing mode is switched to the filter application mode, the touch screen displays each filtered image filtered by a plurality of filters, and wherein, when a user' touch is located at one of areas where the plurality of filtered images are located, the touch screen displays only the filtered images displayed in the corresponding area on the full screen.

28. The mobile terminal of claim 1, wherein the touch screen comprises a pressure electrode and a reference potential layer, and wherein the control unit determines whether or not the touch pressure having a magnitude greater than a predetermined magnitude is applied on the basis of a capacitance change amount according to a change of a distance between the pressure electrode and the reference potential layer, which is changed by the touch pressure.

29. A method for switching photographing modes in a mobile terminal which comprises a camera unit photographing a subject and a touch screen capable of detecting a touch pressure, the method comprising:
an initial photographing step of photographing a subject in a first photographing mode;
a displaying step of displaying the obtained image on the touch screen;
a determining step of determining whether a touch pressure having a magnitude greater than a predetermined magnitude is applied to the touch screen or not; and
a switching photographing step of, when the touch pressure having a magnitude greater than the predetermined magnitude is applied, switching the photographing mode from the first photographing mode to a second photographing mode and of photographing an image.

30. The method of claim 29, further comprising, a step of switching the photographing mode to the first photographing mode again when the touch pressure is released and of controlling the subject to be photographed.

31. The method of claim 29, further comprising a step of setting the first photographing mode and the second photographing mode on the basis of a touch input through the touch screen.

32. The method of claim 29, further comprising:
a step of storing the image obtained in the first photographing mode and the second photographing mode; and
a step of reading the stored image and displaying on the touch screen.

33. The method of claim 29,
wherein the first photographing mode is a picture photographing mode for photographing a still image, and the second photographing mode is a video photographing mode for photographing a dynamic image,
and wherein, in the switching photographing step, video photographing is started at a point of time when the touch pressure is released.

34. The method of claim 29,
wherein the first photographing mode is a picture photographing mode for photographing a still image, and the second photographing mode is a video photographing mode for photographing a dynamic image,
and wherein, in the switching photographing step, video photographing is started at a point of time when the photographing mode is switched to the video photographing mode, and the video photographing is ended when the touch pressure is released.

35. The method of claim 34, further comprising a step of storing the photographed video image when the touch pressure is released, and of switching the photographing mode to the first photographing mode again.

36. The method of claim 29,
wherein the camera unit comprises a first camera and a second camera which are spaced by a predetermined distance from each other,
wherein the first photographing mode is a 2D photographing mode for photographing a 2D image by using one of the first camera and the second camera, and the second photographing mode is a 3D photographing mode for photographing a 3D image by using the first camera and the second camera,
and further comprising a step of reconstructing a 3D image by using the image obtained by the first camera and the second camera.

37. The method of claim 29,
wherein the camera unit comprises a first camera and a second camera, and one or more of an angle of view, a minimum aperture value, a shortest object distance, a zoom magnification, the number of pixels, and ISO of the first and second cameras are different from each other,
wherein the first photographing mode is a mode for photographing an image by using the first camera, and the second photographing mode is a mode for photographing an image by using the second camera.

38. The method of claim 29,
wherein the camera unit comprises a front side camera disposed on a front side of the mobile terminal and a rear side camera disposed on a rear side of the mobile terminal,
wherein the first photographing mode is a front camera mode for photographing by using the front side camera, and the second photographing mode is a rear camera mode for photographing by using the rear side camera.

39. The method of claim 29,
wherein the first photographing mode is a picture photographing mode for photographing a still image, and the second photographing mode is a depth-of-field control mode for pan-focusing photographing or out-focusing photographing,
and wherein, in the switching photographing step, the photographing is performed by controlling a depth-of-field of the image on the basis of at least one of an aperture value and a focal length.

40. The method of claim 39, wherein, in the switching photographing step, a pan-focusing image or an out-focusing image of the subject is photographed on the basis of at least one of the touch pressure and a movement direction of the touch.

41. The method of claim 40, wherein, in the switching photographing step, the depth-of-field of the image is controlled to gradually decrease when an intensity of the touch pressure increases, and the depth-of-field of the image is controlled to gradually increase when the intensity of the touch pressure decreases.

42. The method of claim 29,
wherein the first photographing mode is a video photographing mode for photographing a dynamic image,
wherein the second photographing mode is a speed control photographing mode for high speed photographing or low speed photographing,
and wherein, in the switching photographing step, the subject is photographed at a low speed or at a high speed by controlling the number of frames obtained according to time.

43. The method of claim 42, wherein, in the switching photographing step, one of the low speed photographing and the high speed photographing is selected on the basis of at least one of an intensity of the touch pressure and a movement direction of the touch.

44. The method of claim 29,
wherein the first photographing mode is a picture photographing mode for photographing a still image, and the second photographing mode is a panoramic photographing mode for photographing a panoramic image,
and wherein, in the switching photographing step, a guide line for guiding a movement direction of the camera is displayed.

45. The method of claim 44, wherein, in the switching photographing step, panoramic photographing is started at a point of time when the touch pressure is released.

46. The method of claim 44, wherein, in the switching photographing step, the panoramic photographing is started at a point of time when the photographing mode is switched to the panoramic photographing mode, and the panoramic photographing is ended at a point of time when the touch pressure is released.

47. The method of claim 29,
wherein the second photographing mode is a white balance adjustment mode for controlling a color temperature of an image,
and wherein, in the switching photographing step, the color temperature of the image is controlled on the basis of at least one of an intensity of the touch pressure and a movement direction of the touch.

48. The method of claim 47, wherein, in the switching photographing step, a change of a numerical value of the color temperature based on at least one of the intensity of the touch pressure and the movement of the touch is displayed.

49. The method of claim 29,
wherein the second photographing mode is a filter application mode for obtaining a filtered image,
and wherein, in the switching photographing step, the touch screen displays each filtered image filtered by a plurality of filters, and when a user' touch is located at one of areas where the plurality of filtered images are located, the touch screen displays only the filtered images displayed in the corresponding area on the full screen.

50. The method of claim 29,
wherein the second photographing mode is a timer photographing mode for photographing an image after a predetermined time is counted,
and wherein, in the switching photographing step, the image is obtained after the predetermined time is counted after the photographing is started.

51. The method of claim 50,
wherein the predetermined time is a time from when the photographing mode is switched to the timer photographing mode to when the touch pressure is released,
and wherein, in the switching photographing step, the image is obtained at a point of time when the touch pressure is released.

52. The method of claim 50, wherein, in the switching photographing step, the predetermined time or a change of time which is counted is displayed on the touch screen.

53. The method of claim 29,
wherein the touch screen comprises a pressure electrode and a reference potential layer,
and wherein, in the determining step, it is determined whether or not the touch pressure having a magnitude greater than a predetermined magnitude is applied to the touch screen, on the basis of a capacitance change amount according to a change of a distance between the pressure electrode and the reference potential layer, which is changed by the touch pressure.
